(19) Europäisches Patentamt
European Patent Office
Office européen des brevets

(11) **EP 4 040 186 A1**

(12) **EUROPEAN PATENT APPLICATION**
published in accordance with Art. 153(4) EPC

(43) Date of publication:
**10.08.2022 Bulletin 2022/32**

(21) Application number: **20872140.7**

(22) Date of filing: **17.09.2020**

(51) International Patent Classification (IPC):
**G01S 7/484** (2006.01)   **G01S 17/26** (2020.01)
**H05B 47/155** (2020.01)

(52) Cooperative Patent Classification (CPC):
**G01S 7/484; G01S 17/26; H05B 47/155;**
Y02B 20/40

(86) International application number:
**PCT/JP2020/035275**

(87) International publication number:
**WO 2021/065542 (08.04.2021 Gazette 2021/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.09.2019 JP 2019179330**

(71) Applicant: **Sony Semiconductor Solutions Corporation**
**Atsugi-shi Kanagawa 243-0014 (JP)**

(72) Inventor: **HANNURKAR, Jayesh**
**Atsugi-shi, Kanagawa 243-0014 (JP)**

(74) Representative: **Müller Hoffmann & Partner Patentanwälte mbB**
**St.-Martin-Strasse 58**
**81541 München (DE)**

(54) **ILLUMINATION DEVICE, ILLUMINATION DEVICE CONTROL METHOD, AND DISTANCE MEASUREMENT MODULE**

(57)    The present technology relates to a lighting device, a method for controlling the lighting device, and a distance measurement module that make it possible to reduce a cyclic error.

The lighting device includes a plurality of light sources including a first light source and a second light source, and a drive unit that drives the plurality of light sources. The drive unit causes the first light source and the second light source to emit light at different timings and light emission periods to cause a light emission intensity by the plurality of light sources to have symmetry in a time direction in a time width of one cycle around a peak value or a minimum value. The present technology can be applied to, for example, a distance measurement module that measures a distance to a subject, and the like.

*FIG. 7*

EP 4 040 186 A1

**Description**

TECHNICAL FIELD

The present technology relates to a lighting device, a method for controlling the lighting device, and a distance measurement module, and particularly relates to a lighting device, a method for controlling the lighting device, and a distance measurement module enabled to reduce a cyclic error.

BACKGROUND ART

In recent years, with the progress of semiconductor technology, downsizing of a distance measurement module that measures a distance to an object has progressed. As a result, for example, it is implemented that the distance measurement module is mounted on a mobile terminal such as a smartphone.

As a distance measurement method in the distance measurement module, for example, there is a method called a time of flight (ToF) method. In the ToF method, light is emitted toward an object and light reflected on a surface of the object is detected, and a distance to the object is calculated on the basis of a measured value obtained by measuring a flight time of the light. As a light emitting source that emits light, for example, a laser diode array is used that performs surface emission as disclosed in Patent Documents 1 and 2.

CITATION LIST

PATENT DOCUMENT

Patent Document 1: Japanese Patent Application Laid-Open No. 2016-132235
Patent Document 2: Japanese Patent Application Laid-Open No. 2015-18981

SUMMARY OF THE INVENTION

PROBLEMS TO BE SOLVED BY THE INVENTION

In measurement of a distance, modulated light output from a light emitting source is subjected to signal processing as a sine waveform, but since the light actually output from the light emitting source has a rectangular waveform, processing the rectangular wave as a sine wave causes a periodic error (hereinafter, referred to as a cyclic error) in a measured value.

The present technology has been made in view of such a situation, and it is intended to make it possible to reduce the cyclic error.

SOLUTIONS TO PROBLEMS

A lighting device according to a first aspect of the present technology includes: a plurality of light sources including a first light source and a second light source; and a drive unit that drives the plurality of light sources, in which the drive unit causes the first light source and the second light source to emit light at different timings and light emission periods to cause a light emission intensity by the plurality of light sources to have symmetry in a time direction in a time width of one cycle around a peak value or a minimum value.

A method for controlling a lighting device according to a second aspect of the present technology is a method for controlling a lighting device including: a plurality of light sources including a first light source and a second light source; and a drive unit that drives the plurality of light sources, the method including causing, by the drive unit, the first light source and the second light source to emit light at different timings and light emission periods to cause a light emission intensity by the plurality of light sources to have symmetry in a time direction in a time width of one cycle around a peak value or a minimum value.

A distance measurement module according to a third aspect of the present technology includes: a lighting device; and a distance measurement sensor, in which the lighting device includes: a plurality of light sources including a first light source and a second light source; and a drive unit that drives the plurality of light sources, in which the drive unit causes the first light source and the second light source to emit light at different timings and light emission periods to cause a light emission intensity by the plurality of light sources to have symmetry in a time direction in a time width of one cycle around a peak value or a minimum value.

In the first to third aspects of the present technology, the first light source and the second light source emit light at the different timings and the light emission periods to cause the light emission intensity by the plurality of light sources including the first light source and the second light source to have symmetry in the time direction in the time width of one cycle around the peak value or the minimum value.

The lighting device and the distance measurement module may be an independent device or a module incorporated in another device.

BRIEF DESCRIPTION OF DRAWINGS

Fig. 1 is a block diagram illustrating a configuration example of a first embodiment of a distance measurement module to which the present technology is applied.
Fig. 2 is a diagram explaining a distance measurement principle of an indirect ToF method.
Fig. 3 is a diagram explaining a cyclic error and correction processing thereof.
Fig. 4 is a block diagram illustrating a detailed configuration example of a first configuration example of a light emitting unit.
Fig. 5 is a plan view of a light emitting surface of the light emitting unit according to the first configuration example.
Fig. 6 is a diagram illustrating a light reception start signal and a light emission timing signal.
Fig. 7 is a diagram illustrating a light emission intensity of the entire light emitting unit at each timing.
Fig. 8 is a diagram illustrating a modification of the first configuration example of the light emitting unit.
Fig. 9 is a block diagram illustrating a detailed configuration example of a second configuration example of the light emitting unit.
Fig. 10 is a plan view of a light emitting surface of a light emitting unit according to the second configuration example.
Fig. 11 is a diagram illustrating a light reception start signal and a light emission timing signal.
Fig. 12 is a diagram illustrating light emission timing signals delayed by delay circuits.
Fig. 13 is a diagram illustrating light emission timing signals delayed by delay circuits.
Fig. 14 is a diagram illustrating a light emission intensity of the entire light emitting unit at each timing.
Fig. 15 is a block diagram illustrating a configuration example of a second embodiment of the distance measurement module to which the present technology is applied.
Fig. 16 is a block diagram illustrating a detailed configuration example of a light emitting unit according to the second embodiment.
Fig. 17 is a diagram illustrating a circuit configuration example of a laser driver and one laser light source.
Fig. 18 is a diagram illustrating a circuit configuration example of a laser driver and three laser light sources.
Fig. 19 is a flowchart explaining light emission intensity adjustment processing.
Fig. 20 is a perspective view illustrating a chip configuration example of the distance measurement module.
Fig. 21 is a block diagram illustrating a configuration example of an electronic device to which the present technology is applied.
Fig. 22 is a block diagram illustrating an example of a schematic configuration of a vehicle control system.
Fig. 23 is an explanatory diagram illustrating an example of installation positions of a vehicle exterior information detecting unit and an imaging unit.

MODE FOR CARRYING OUT THE INVENTION

Hereinafter, a mode for carrying out the present technology (the mode will be hereinafter referred to as the embodiment) will be described with reference to the accompanying drawings. Note that, in the present specification and the drawings, components having substantially the same functional configuration are denoted by the same reference signs, and redundant explanations will be omitted. The description will be made in the following order.

1. First embodiment of distance measurement module
2. Distance measurement principle of indirect ToF method
3. First configuration example of light emitting unit
4. Modification of first configuration example of light emitting unit
5. Second configuration example of light emitting unit
6. Second embodiment of distance measurement module
7. Configuration example of light emitting unit
8. Light emission intensity adjustment processing
9. Chip configuration example of distance measurement module

10. Configuration example of electronic device

11. Application example to mobile body

<1. First embodiment of distance measurement module>

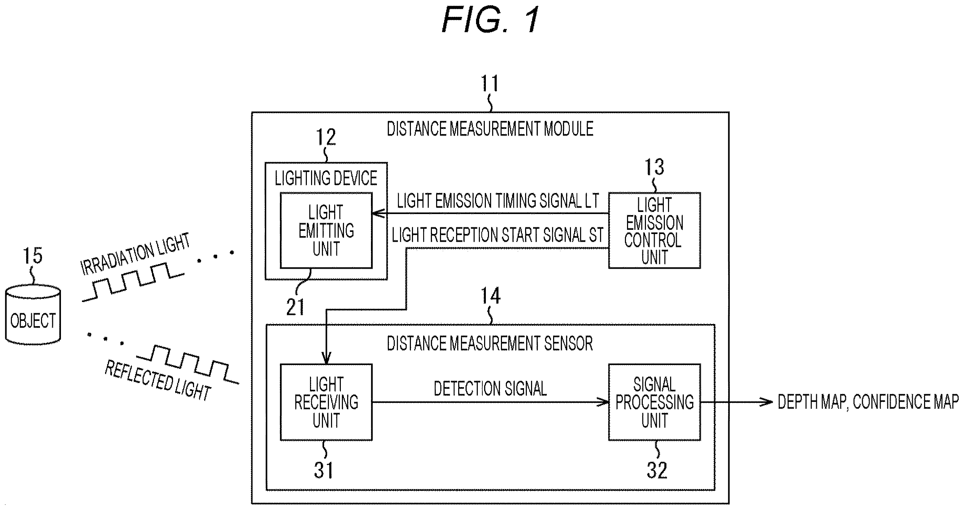

Fig. 1 is a block diagram illustrating a configuration example of a first embodiment of a distance measurement module to which the present technology is applied.

A distance measurement module 11 according to the first embodiment is a distance measurement module that performs distance measurement by an indirect ToF method, and includes a lighting device 12, a light emission control unit 13, and a distance measurement sensor 14.

The distance measurement module 11 emits light to a predetermined object 15 as an object to be measured, and receives light (reflected light) obtained by reflecting the light (irradiation light) by the object 15. Then, the distance measurement module 11 outputs a depth map representing distance information to the object 15 and a confidence map, as measurement results, on the basis of a light reception result.

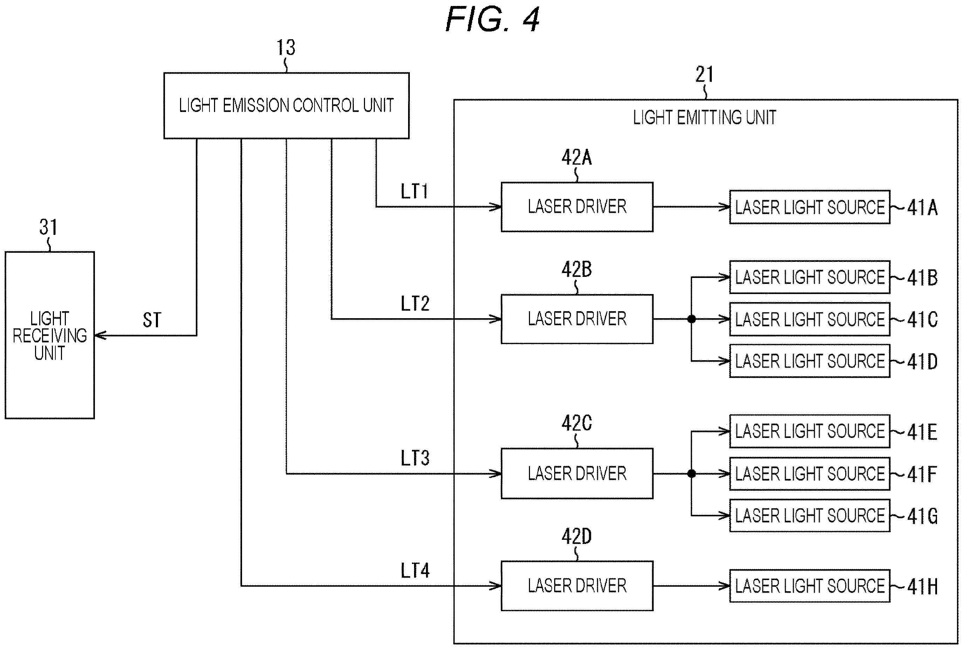

The lighting device 12 includes, for example, a light emitting unit 21 in which a plurality of laser light sources 41 (Fig. 4) including a light emitting element such as a vertical cavity surface emitting laser (VCSEL) is arranged in a planar direction.

The light emitting unit 21 emits light while performing modulation at a timing depending on a light emission timing signal LT supplied from the light emission control unit 13, and emits irradiation light to the object 15. For example, in a case where the irradiation light is infrared light, the wavelength of the irradiation light ranges from about 850 nm to 940 nm.

The light emission control unit 13 controls light emission by supplying the light emission timing signal LT of a predetermined frequency (for example, 20 MHz or the like) to the light emitting unit 21. Furthermore, the light emission control unit 13 supplies a light reception start signal ST to the distance measurement sensor 14 to drive the distance measurement sensor 14 in accordance with a timing of light emission in the light emitting unit 21. Note that, the light emission control unit 13 can be incorporated as a part of the lighting device 12 or the distance measurement sensor 14.

The distance measurement sensor 14 includes a light receiving unit 31 and a signal processing unit 32.

The light receiving unit 31 receives reflected light from the object 15 by a pixel array in which a plurality of pixels is two-dimensionally arranged in a matrix in the row direction and the column direction. Then, the light receiving unit 31 supplies a detection signal depending on an amount of received light of the received reflected light to the signal processing unit 32 in units of pixels of the pixel array.

The signal processing unit 32 calculates a depth value that is a distance from the distance measurement module 11 to the object 15 on the basis of the detection signal supplied from the light receiving unit 31 for each pixel of the pixel array. Then, the signal processing unit 32 generates a depth map in which the depth value is stored as a pixel value of each pixel and a confidence map in which a confidence value is stored as a pixel value of each pixel, and outputs the depth map and the confidence map to the outside of the module.

<2. Distance measurement principle of indirect ToF method>

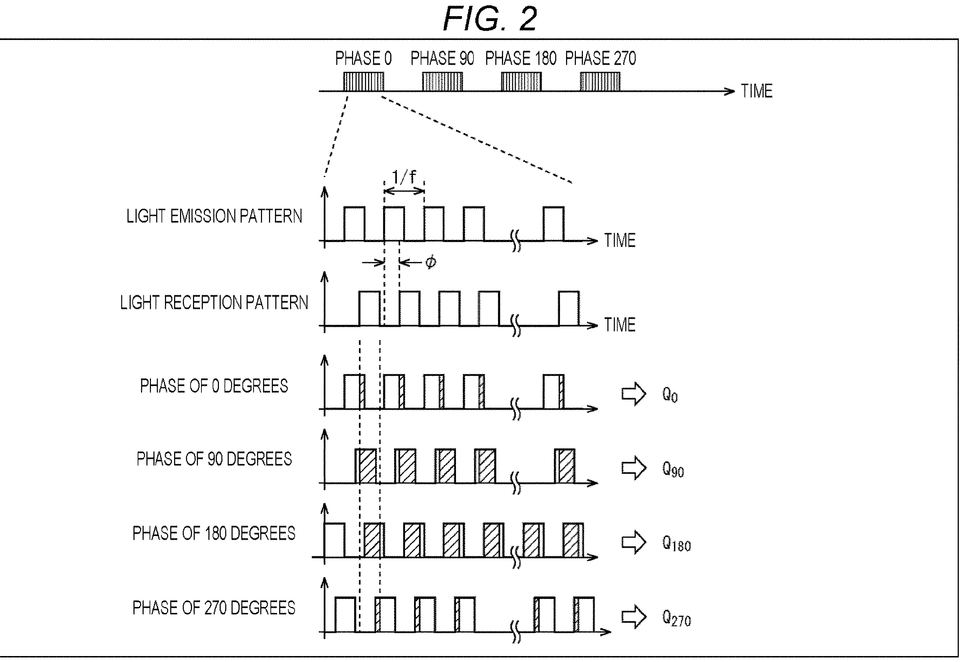

Before specific processing of the present disclosure is described, a distance measurement principle of the indirect ToF method will be briefly described with reference to Fig. 2.

A depth value d [mm] corresponding to the distance from the distance measurement module 11 to the object 15 can be calculated by the following expression (1).

[Expression 1]

$$d = \frac{1}{2} \cdot c \cdot \Delta t \qquad \cdot \cdot \cdot (1)$$

In the expression (1), $\Delta t$ is a time until the irradiation light emitted from the light emitting unit 21 is reflected by the object 15 and is incident on the light receiving unit 31, and c represents the speed of light.

As the irradiation light emitted from the light emitting unit 21, as illustrated in Fig. 2, pulsed light is adopted of a light emission pattern that repeatedly turns on and off at a high speed at a predetermined frequency f (modulation frequency). One cycle T of the light emission pattern is 1/f. In the light receiving unit 31, the phase of the reflected light (light reception pattern) is detected to be shifted depending on the time $\Delta t$ until the irradiation light reaches the light receiving unit 31 from the light emitting unit 21. When an amount of shift of the phase (phase difference) between the light emission pattern and the light reception pattern is $\varphi$, the time $\Delta t$ can be calculated by the following expression (2).

[Expression 2]

$$\Delta t = \frac{1}{f} \cdot \frac{\phi}{2\pi} \qquad \cdots (2)$$

Thus, the depth value d from the distance measurement module 11 to the object 15 can be calculated by the following expression (3) from the expressions (1) and (2).
[Expression 3]

$$d = \frac{c\phi}{4\pi f} \qquad \cdots (3)$$

Next, a method for calculating the above-described phase difference $\varphi$ will be described.
Each pixel of the pixel array formed in the light receiving unit 31 repeats ON/OFF at a high speed and accumulates charges only during ON periods.
The light receiving unit 31 sequentially switches an execution timing of ON/OFF of each pixel of the pixel array, accumulates charges at each execution timing, and outputs a detection signal depending on the accumulated charges.
There are four types of ON/OFF execution timings, for example, a phase of 0 degrees, a phase of 90 degrees, a phase of 180 degrees, and a phase of 270 degrees.
The execution timing of the phase of 0 degrees is a timing at which the ON timing (light reception timing) of each pixel of the pixel array is set to the phase of the pulsed light emitted by the light source of the light emitting unit 21, that is, the same phase as the light emission pattern.
The execution timing of the phase of 90 degrees is a timing at which the ON timing (light reception timing) of each pixel of the pixel array is delayed by 90 degrees from the pulsed light (light emission pattern) emitted by the light source of the light emitting unit 21.
The execution timing of the phase of 180 degrees is a timing at which the ON timing (light reception timing) of each pixel of the pixel array is delayed by 180 degrees from the pulsed light (light emission pattern) emitted by the light source of the light emitting unit 21.
The execution timing of the phase of 270 degrees is a timing at which the ON timing (light reception timing) of each pixel of the pixel array is delayed by 270 degrees from the pulsed light (light emission pattern) emitted by the light source of the light emitting unit 21.
The light receiving unit 31 sequentially switches the light reception timings in the order of, for example, the phase of 0 degrees, the phase of 90 degrees, the phase of 180 degrees, and the phase of 270 degrees, and acquires the amount of received light of the reflected light (accumulated charge) at each light reception timing. In Fig. 2, at the light reception timing (ON timing) of each phase, the timing at which the reflected light is incident is shaded.
As illustrated in Fig. 2, assuming that $Q_0$, $Q_{90}$, $Q_{180}$, and $Q_{270}$ are charges accumulated when the light reception timing is set to the phase of 0 degrees, the phase of 90 degrees, the phase of 180 degrees, and the phase of 270 degrees, respectively, the phase difference $\varphi$ can be calculated by the following expression (4) using $Q_0$, $Q_{90}$, $Q_{180}$, and $Q_{270}$.
[Expression 4]

$$\phi = \mathrm{Arctan}\, \frac{Q_{90} - Q_{270}}{Q_{180} - Q_0} \qquad \cdots (4)$$

The depth value d from the distance measurement module 11 to the object 15 can be calculated by inputting the phase difference $\varphi$ calculated by the expression (4) to the expression (3) described above.
Furthermore, a degree of confidence conf is a value representing an intensity of light received by each pixel, and can be calculated by, for example, the following expression (5).
[Expression 5]

$$\mathrm{conf} = \sqrt{(Q_{180} - Q_0)^2 + (Q_{90} - Q_{270})^2} \qquad \cdots (5)$$

In each pixel of the pixel array, the light receiving unit 31 sequentially switches the light reception timing to the phase of 0 degrees, the phase of 90 degrees, the phase of 180 degrees, and the phase of 270 degrees as described above, and sequentially supplies the detection signal corresponding to the accumulated charge (charge $Q_0$, charge $Q_{90}$, charge $Q_{180}$, and charge $Q_{270}$) in each phase to the signal processing unit 32. Note that, by providing two charge accumulation units in each pixel of the pixel array and alternately accumulating charges in the two charge accumulation units, it is possible to acquire, in one frame, detection signals of two light reception timings whose phases are inverted from each other, as the phase of 0 degrees and the phase of 180 degrees, for example.

The signal processing unit 32 calculates the depth value d that is a distance from the distance measurement module 11 to the object 15 on the basis of the detection signal supplied from the light receiving unit 31 for each pixel of the pixel array. Then, a depth map in which the depth value d is stored as the pixel value of each pixel and a confidence map in which the degree of confidence conf is stored as the pixel value of each pixel are generated and output from the signal processing unit 32 to the outside of the module.

The above-described expression (4) is calculated assuming that a luminance change of the irradiation light emitted from the light emitting unit 21 is a sine wave. However, actually, since the light emitted from the light emitting unit 21 is a rectangular wave as illustrated in Fig. 2, a periodic error (hereinafter, referred to as a cyclic error) occurs in the distance (depth value) d by processing the rectangular wave as a sine wave.

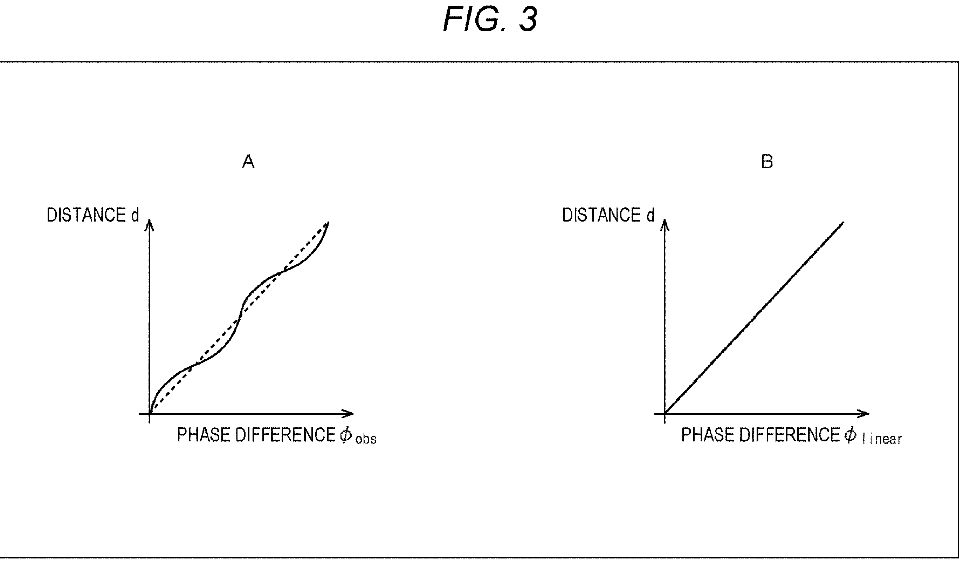

A of Fig. 3 is a graph illustrating a relationship between a phase difference $\varphi_{obs}$ and the distance d in a state including the cyclic error.

In the state including the cyclic error, the phase difference $\varphi_{obs}$ and the distance d have a non-linear relationship as indicated by a solid line with respect to an ideal relationship indicated by a broken line in A of Fig. 3.

For the cyclic error, generally, as illustrated in B of Fig. 3, a correction coefficient for converting the phase difference $\varphi_{obs}$ into a true value phase difference $\varphi_{linear}$ is calculated in advance (before shipment) by using an object to be measured whose distance information is known, and correction processing is performed by using the correction coefficient at the time of measurement.

On the other hand, the distance measurement module 11 in Fig. 1 controls the light emission of the light emitting unit 21 so that the irradiation light emitted from the light emitting unit 21 of the lighting device 12 becomes a pseudo sine wave (pseudo sine wave). As a result, since the cyclic error is reduced, the relationship between the phase difference $\varphi$ and the distance d becomes linear, and the correction processing can be made unnecessary.

Hereinafter, the lighting device 12 that emits the pseudo sine wave will be described in detail.

### <3. First configuration example of light emitting unit>

Fig. 4 is a block diagram illustrating details of a first configuration example of the light emitting unit 21 of the lighting device 12. Note that, Fig. 4 also illustrates the light emission control unit 13 and the light receiving unit 31.

The light emitting unit 21 in Fig. 4 includes eight laser light sources 41 and four laser drivers 42 that drive the laser light sources. In Fig. 4, in a case where the eight laser light sources 41 are distinguished from each other, they are referred to as laser light sources 41A to 41H, and in a case where the four laser drivers 42 are distinguished from each other, they are referred to as laser drivers 42A to 42D.

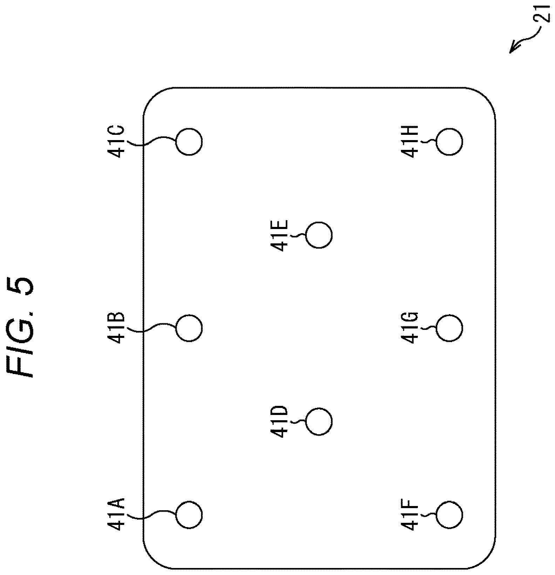

Fig. 5 is a plan view of a light emitting surface of the light emitting unit 21 according to the first configuration example.

As illustrated in Fig. 5, eight laser light sources 41A to 41H are arranged in the planar direction at regular intervals, for example.

Returning to Fig. 4, the laser driver 42A drives the one laser light source 41A on the basis of a light emission timing signal LT1 from the light emission control unit 13. The laser driver 42B drives the three laser light sources 41B to 41D on the basis of a light emission timing signal LT2 from the light emission control unit 13. Furthermore, the laser driver 42C drives the three laser light sources 41E to 41G on the basis of a light emission timing signal LT3 from the light emission control unit 13, and the laser driver 42D drives the one laser light source 41H on the basis of a light emission timing signal LT4 from the light emission control unit 13.

The light emission control unit 13 supplies the light emission timing signals LT1 to LT4 to the light emitting unit 21, and supplies the light reception start signal ST to the light receiving unit 31 of the distance measurement sensor 14.

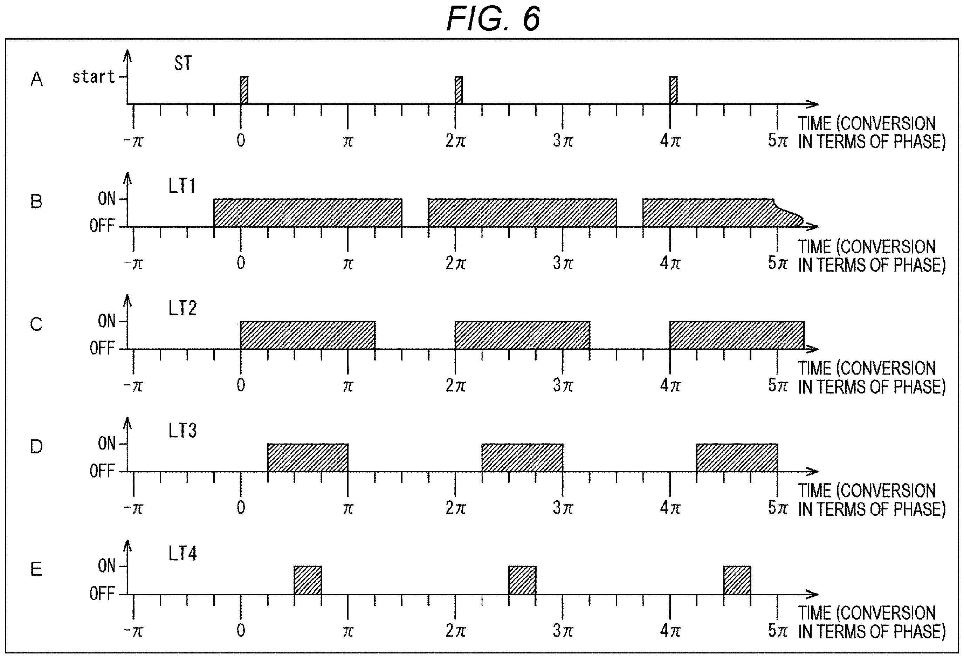

Fig. 6 illustrates the light reception start signal ST and the light emission timing signals LT1 to LT4 output from the light emission control unit 13.

A of Fig. 6 illustrates an example of the light reception start signal ST. B of Fig. 6 illustrates an example of the light emission timing signal LT1. C of Fig. 6 illustrates an example of the light emission timing signal LT2. D of Fig. 6 illustrates an example of the light emission timing signal LT3. E of Fig. 6 illustrates an example of the light emission timing signal LT4.

The light reception start signal ST includes a pulse signal at High or Low, and reception (exposure) of reflected light is started in each pixel of the light receiving unit 31 at rising from Low to High.

The light emission timing signals LT1 to LT4 each include a pulse signal at High or Low, and the laser light source 41 emits light corresponding to a period at High.

In A to E of Fig. 6, the horizontal axis represents time expressed by a conversion in terms of phase.

The light reception start signal ST in A of Fig. 6 is a signal corresponding to the light reception timing of the phase of 0 degrees among the light reception timings of phases of the phase of 0 degrees, the phase of 90 degrees, the phase of 180 degrees, and the phase of 270 degrees illustrated in Fig. 2. That is, by the light reception start signal ST in A of Fig. 6, each pixel of the light receiving unit 31 starts light reception at the phase of 0 degrees.

As illustrated in B of Fig. 6, the one laser light source 41A emits light for a period from a phase ($-\pi/4$) to a phase ($6\pi/4$) in accordance with the light emission timing signal LT1.

As illustrated in C of Fig. 6, the three laser light sources 41B to 41D emit light for a period from a phase 0 to a phase ($5\pi/4$) in accordance with the light emission timing signal LT2.

As illustrated in D of Fig. 6, the three laser light sources 41E to 41G emit light for a period from a phase ($\pi/4$) to a phase ($4\pi/4$) in accordance with the light emission timing signal LT3.

As illustrated in E of Fig. 6, the one laser light source 41H emits light for a period from a phase ($2\pi/4$) to a phase ($3\pi/4$) in accordance with the light emission timing signal LT4.

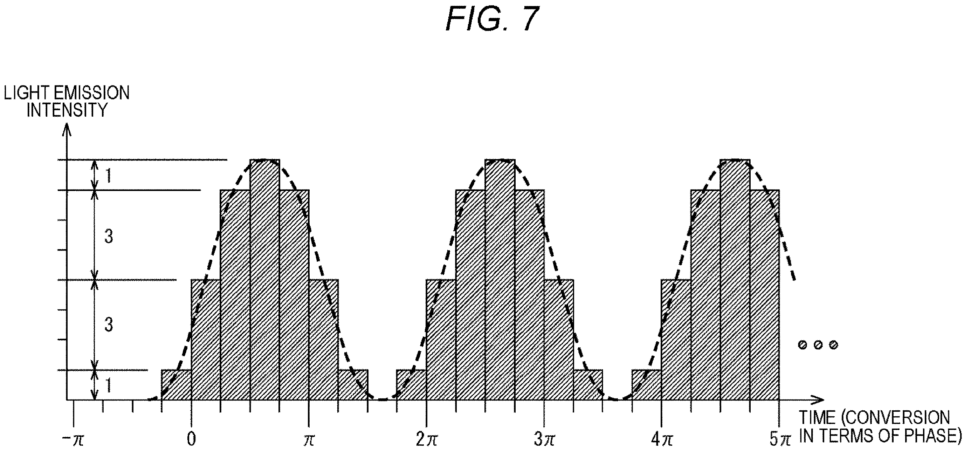

Fig. 7 illustrates a light emission intensity (light emission luminance) of the entire light emitting unit 21 at each timing in a conversion in terms of phase in a case where the eight laser light sources 41A to 41H emit light as illustrated in Fig. 6.

The light emission intensity at each timing in a conversion in terms of phase of the entire light emitting unit 21 is proportional to the number of laser light sources 41 emitting light at each timing. Assuming that the light emission intensity in a case where one laser light source 41 emits light is 1, the light emission intensity in a period in which three laser light sources 41 simultaneously emit light is 3, the light emission intensity in a period in which seven laser light sources 41 simultaneously emit light is 7, and the light emission intensity in a period in which all (that is, eight) laser light sources 41 simultaneously emit light is 8.

That is, as illustrated in Fig. 7, the light emission intensity as the entire light emitting unit 21 at each timing has symmetry in a time direction in a time width of one cycle around a peak value or a minimum value of the light emission intensity, and becomes a light emission intensity approximate to a sine wave indicated by a broken line.

Thus, since the irradiation light emitted from the light emitting unit 21 can be a pseudo sine wave (pseudo sine wave), the cyclic error can be reduced, and the correction processing can be made unnecessary.

<4. Modification of first configuration example of light emitting unit>

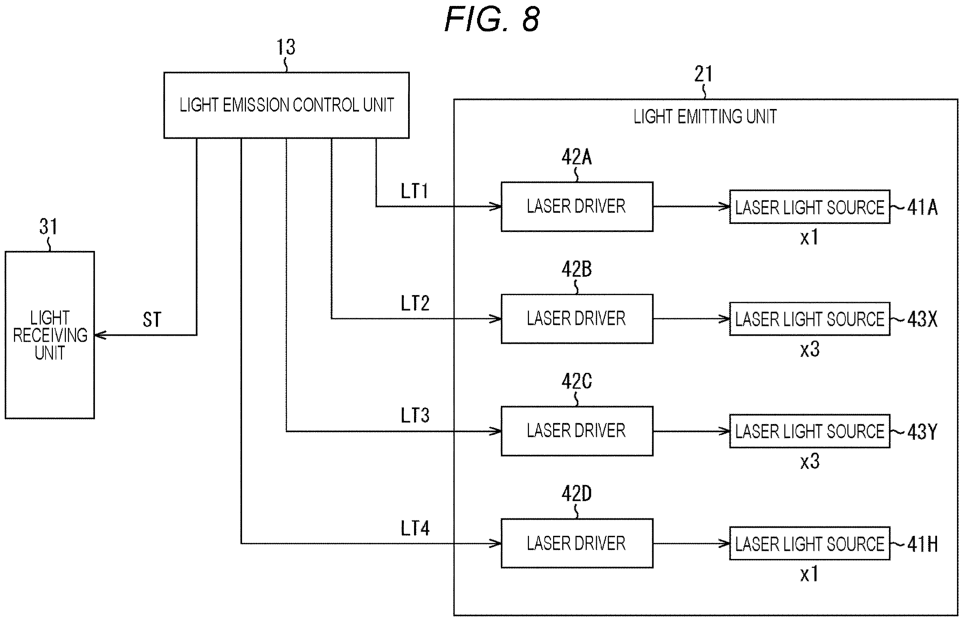

Fig. 8 illustrates a modification of the first configuration example of the light emitting unit 21.

The light emitting unit 21 according to the modification of Fig. 8 has a configuration in which the three laser light sources 41B to 41D of the first configuration example illustrated in Fig. 5 are replaced with one laser light source 43X, and the three laser light sources 41E to 41G are replaced with one laser light source 43Y. Other configurations of the light emitting unit 21 in Fig. 8 are similar to those of the light emitting unit 21 in Fig. 5.

In the first configuration example described above, the laser driver 42B causes the three laser light sources 41B to 41D to simultaneously emit light in accordance with the light emission timing signal LT2, but in the modification of Fig. 8, the one laser light source 43X is caused to emit light. However, the light emission intensity of the one laser light source 43X is three times the light emission intensity of the one laser light source 41. That is, when the one laser light source 43X is caused to emit light, the light emission intensity is the same as that when the three laser light sources 41B to 41D are caused to simultaneously emit light.

Similarly, in the first configuration example described above, the laser driver 42C causes the three laser light sources 41E to 41G to simultaneously emit light in accordance with the light emission timing signal LT3, but in the modification of Fig. 8, the one laser light source 43Y is caused to emit light. However, the light emission intensity of the one laser light source 43Y is three times the light emission intensity of the one laser light source 41. That is, when the one laser light source 43Y is caused to emit light, the light emission intensity is the same as that when the three laser light sources 41E to 41G are caused to simultaneously emit light.

Also in such a configuration, by causing the laser light sources 41 and 43 to emit light at the light emission timing illustrated in Fig. 6, the light emission intensity as the entire light emitting unit 21 at each timing becomes a light emission intensity approximate to a sine wave as illustrated in Fig. 7.

Thus, the cyclic error can be reduced, and the correction processing can be made unnecessary.

<5. Second configuration example of light emitting unit>

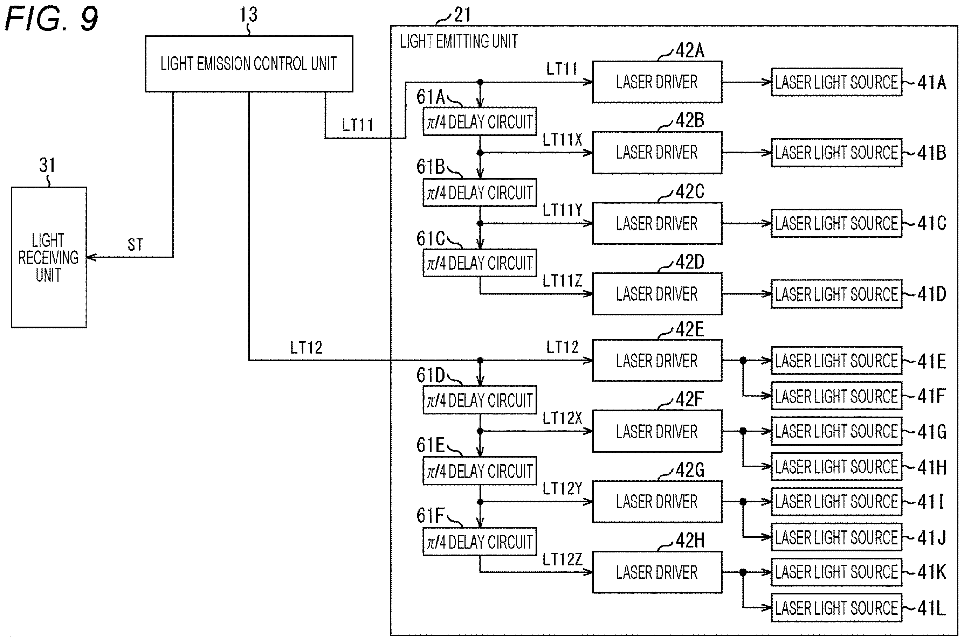

Fig. 9 is a block diagram illustrating details of a second configuration example of the light emitting unit 21, and the light emission control unit 13 and the light receiving unit 31.

The light emitting unit 21 in Fig. 9 includes twelve laser light sources 41, eight laser drivers 42 that drive the laser light sources, and six $\pi/4$ delay circuits 61 (hereinafter, simply referred to as delay circuits 61). In Fig. 9, the twelve laser light sources 41 are referred to as laser light sources 41A to 41L in a case where they are distinguished from each other, the eight laser drivers 42 are referred to as laser drivers 42A to 42H in a case where they are distinguished from each other, and the delay circuits 61 are referred to as delay circuits 61A to 61F in a case where they are distinguished from each other.

Each of the delay circuits 61 delays the supplied light emission timing signal LT (LT11 or LT12) by the time of $\pi/4$ in a conversion in terms of phase, and outputs the delayed light emission timing signal LT to the subsequent stage. The three delay circuits 61A to 61C are connected together in series in the order of the delay circuits 61A, 61B, and 61C. Furthermore, the three delay circuits 61D to 61F are connected together in series in the order of the delay circuits 61D, 61E, and 61F. Amounts of delay delayed by the six delay circuits 61 are the same as each other.

The light emission control unit 13 supplies the light emission timing signals LT11 and LT12 to the light emitting unit 21, and supplies the light reception start signal ST to the light receiving unit 31 of the distance measurement sensor 14.

The light emission timing signal LT11 supplied from the light emission control unit 13 to the light emitting unit 21 is supplied to the laser driver 42A and the delay circuit 61A. The delay circuit 61A delays the supplied light emission timing signal LT11 by the time of $\pi/4$ in a conversion in terms of phase. When a signal whose phase is delayed by $\pi/4$ in the delay circuit 61A is referred to as a light emission timing signal LT11X, the delay circuit 61A supplies the delayed light emission timing signal LT11X to the laser driver 42B and the delay circuit 61B.

The delay circuit 61B delays the supplied light emission timing signal LT11X by the time of $\pi/4$ in a conversion in terms of phase. When a signal whose phase is delayed by $\pi/4$ in the delay circuit 61B is referred to as a light emission timing signal LT11Y, the delay circuit 61B supplies the delayed light emission timing signal LT11Y to the laser driver 42C and the delay circuit 61C.

The delay circuit 61C delays the supplied light emission timing signal LT11Y by the time of $\pi/4$ in a conversion in terms of phase. When a signal whose phase is delayed by $\pi/4$ in the delay circuit 61C is referred to as a light emission timing signal LT11Z, the delay circuit 61C supplies the delayed light emission timing signal LT11Z to the laser driver 42D.

The laser driver 42A drives the one laser light source 41A on the basis of the light emission timing signal LT11 from the light emission control unit 13.

The laser driver 42B drives the one laser light source 41B on the basis of the light emission timing signal LT11X from the delay circuit 61A.

The laser driver 42C drives the one laser light source 41C on the basis of the light emission timing signal LT11Y from the delay circuit 61B.

The laser driver 42D drives the one laser light source 41D on the basis of the light emission timing signal LT11Z from the delay circuit 61C.

On the other hand, the light emission timing signal LT12 supplied from the light emission control unit 13 to the light emitting unit 21 is supplied to the laser driver 42E and the delay circuit 61D. The delay circuit 61D delays the supplied light emission timing signal LT12 by the time of $\pi/4$ in a conversion in terms of phase. When a signal whose phase is delayed by $\pi/4$ in the delay circuit 61D is referred to as a light emission timing signal LT12X, the delay circuit 61D supplies the delayed light emission timing signal LT12X to the laser driver 42F and the delay circuit 61E.

The delay circuit 61E delays the supplied light emission timing signal LT12X by the time of $\pi/4$ in a conversion in terms of phase. When a signal whose phase is delayed by $\pi/4$ in the delay circuit 61E is referred to as a light emission timing signal LT12Y, the delay circuit 61E supplies the delayed light emission timing signal LT12Y to the laser driver 42G and the delay circuit 61F.

The delay circuit 61F delays the supplied light emission timing signal LT12Y by the time of $\pi/4$ in a conversion in terms of phase. When a signal whose phase is delayed by $\pi/4$ in the delay circuit 61F is referred to as a light emission timing signal LT12Z, the delay circuit 61F supplies the delayed light emission timing signal LT12Z to the laser driver 42H.

The laser driver 42E drives the two laser light sources 41E and 41F on the basis of the light emission timing signal LT12 from the light emission control unit 13.

The laser driver 42F drives the two laser light sources 41G and 41H on the basis of the light emission timing signal LT12X from the delay circuit 61D.

The laser driver 42G drives the two laser light sources 411 and 41J on the basis of the light emission timing signal LT12Y from the delay circuit 61E.

The laser driver 42H drives the two laser light sources 41K and 41L on the basis of the light emission timing signal LT12Z from the delay circuit 61F.

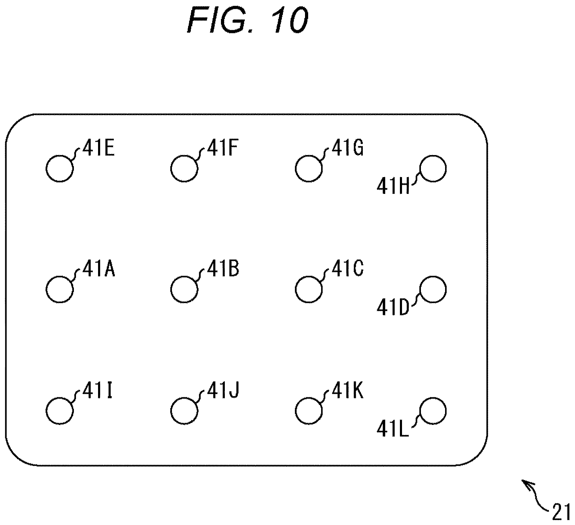

Fig. 10 is a plan view of a light emitting surface of the light emitting unit 21 according to the second configuration example.

For example, as illustrated in Fig. 10, the twelve laser light sources 41A to 41H are arranged in a four x three arrangement in the planar direction.

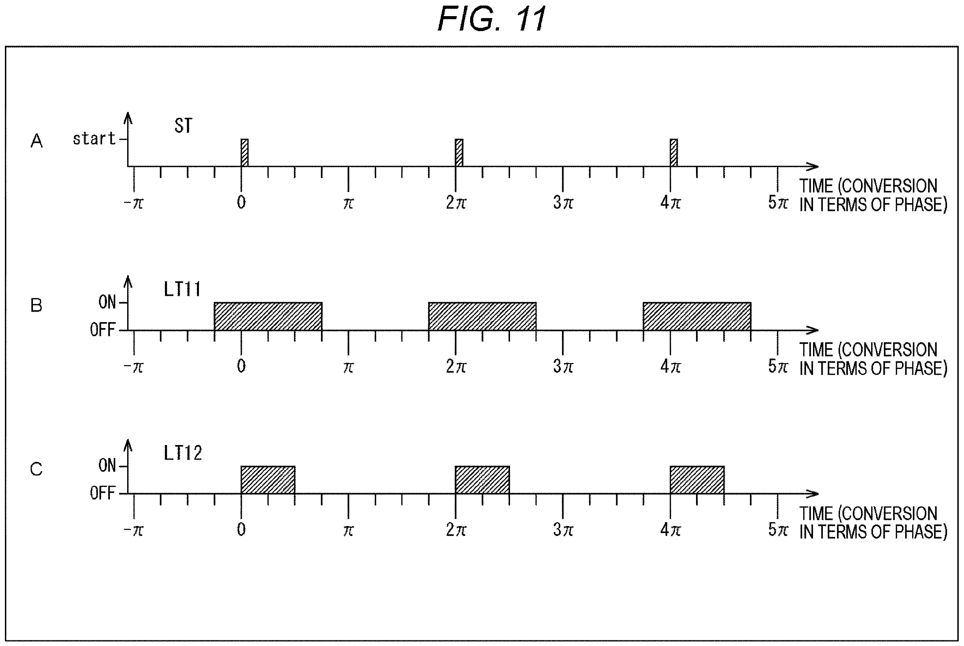

Fig. 11 illustrates the light reception start signal ST and the light emission timing signals LT11 and LT12 output from the light emission control unit 13.

A of Fig. 11 illustrates an example of the light reception start signal ST. B of Fig. 11 illustrates an example of the light emission timing signal LT11. C of Fig. 11 illustrates an example of the light emission timing signal LT12.

In A to C of Fig. 11, similarly to the first configuration example, the horizontal axis represents time expressed by a phase, and light is emitted in periods during which the light emission timing signals LT11 and LT12 are at High.

As illustrated in B of Fig. 11, the light emission timing signal LT11 supplied from the light emission control unit 13 to the light emitting unit 21 is a signal that is set to be High for a period from the phase ($-\pi/4$) to the phase ($3\pi/4$).

On the other hand, as illustrated in C of Fig. 11, the light emission timing signal LT12 supplied from the light emission control unit 13 to the light emitting unit 21 is a signal that is set to be High for a period from the phase 0 to the phase ($2\pi/4$).

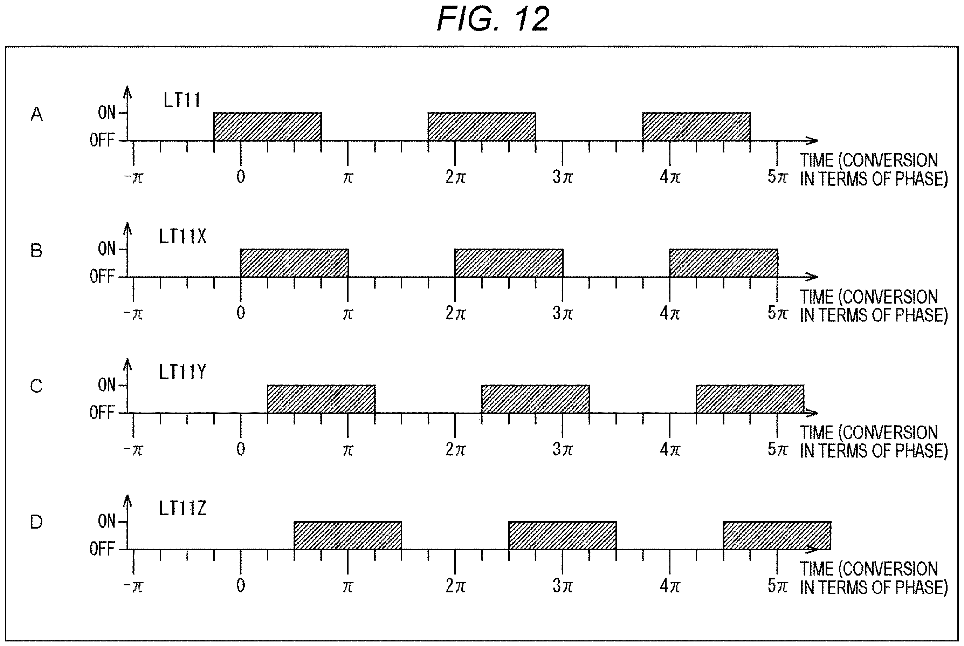

A to D of Fig. 12 illustrate examples of the light emission timing signal LT11 and the light emission timing signals LT11X to LT11Z obtained by delaying the light emission timing signal LT11 by the delay circuits 61A to 61C.

A of Fig. 12 illustrates the same light emission timing signal LT11 as B of Fig. 11. The one laser light source 41A emits light for a period from the phase ($-\pi/4$) to the phase ($3\pi/4$) in accordance with the light emission timing signal LT11.

B of Fig. 12 illustrates the light emission timing signal LT11X. The light emission timing signal LT11X is a signal obtained by delaying the light emission timing signal LT11 by a phase of $\pi/4$ by the delay circuit 61A, and is a signal that is set to be High for a period from the phase 0 to the phase ($4\pi/4$). The one laser light source 41B emits light for a period from the phase 0 to the phase ($4\pi/4$) in accordance with the light emission timing signal LT11X.

C of Fig. 12 illustrates the light emission timing signal LT11Y. The light emission timing signal LT11Y is a signal obtained by delaying the light emission timing signal LT11X by a phase of $\pi/4$ by the delay circuit 61B, and is a signal that is set to be High for a period from the phase ($\pi/4$) to the phase ($5\pi/4$). The one laser light source 41C emits light for a period from the phase ($\pi/4$) to the phase ($5\pi/4$) in accordance with the light emission timing signal LT11Y.

D of Fig. 12 illustrates the light emission timing signal LT11Z. The light emission timing signal LT11Z is a signal obtained by delaying the light emission timing signal LT11Y by a phase of $\pi/4$ by the delay circuit 61C, and is a signal that is set to be High for a period from the phase ($2\pi/4$) to the phase ($6\pi/4$). The one laser light source 41D emits light for a period from the phase ($2\pi/4$) to the phase ($6\pi/4$) in accordance with the light emission timing signal LT11Z.

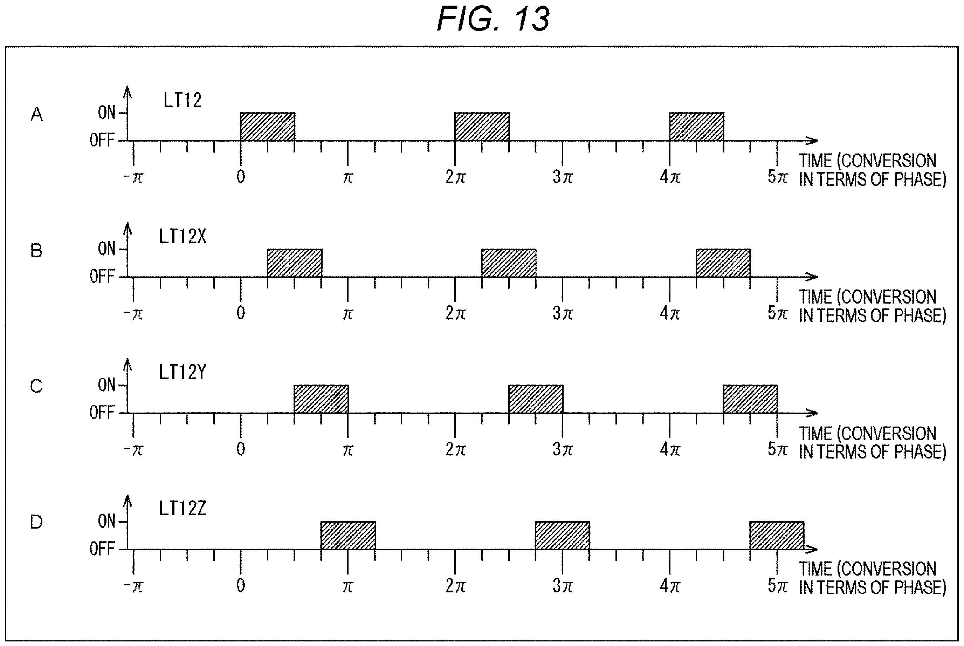

A to D of Fig. 13 illustrate examples of the light emission timing signal LT12 and the light emission timing signals LT12A to LT12Z obtained by delaying the light emission timing signal LT12 by the delay circuits 61D to 61F.

A of Fig. 13 illustrates the same light emission timing signal LT12 as C of Fig. 11. The two laser light sources 41E and 41F emit light for a period from the phase 0 to the phase ($2\pi/4$) in accordance with the light emission timing signal LT12.

B of Fig. 13 illustrates the light emission timing signal LT12X. The light emission timing signal LT12X is a signal obtained by delaying the light emission timing signal LT12 by a phase of $\pi/4$ by the delay circuit 61D, and is a signal that is set to be High for a period from the phase $\pi/4$ to the phase ($3\pi/4$). The two laser light sources 41G and 41H emit light for a period from the phase $\pi/4$ to the phase ($3\pi/4$) in accordance with the light emission timing signal LT12X.

C of Fig. 13 illustrates the light emission timing signal LT12Y. The light emission timing signal LT12Y is a signal obtained by delaying the light emission timing signal LT12X by a phase of $\pi/4$ by the delay circuit 61E, and is a signal that is set to be High for a period from the phase ($2\pi/4$) to the phase ($4\pi/4$). The two laser light sources 411 and 41J emit light for a period from the phase ($2\pi/4$) to the phase ($4\pi/4$) in accordance with the light emission timing signal LT12Y.

D of Fig. 13 illustrates the light emission timing signal LT12Z. The light emission timing signal LT12Z is a signal obtained by delaying the light emission timing signal LT12Y by a phase of $\pi/4$ by the delay circuit 61C, and is a signal that is set to be High for a period from the phase ($3\pi/4$) to the phase ($5\pi/4$). The two laser light sources 41K and 41L emit light for a period from the phase ($3\pi/4$) to the phase ($5\pi/4$) in accordance with the light emission timing signal LT12Z.

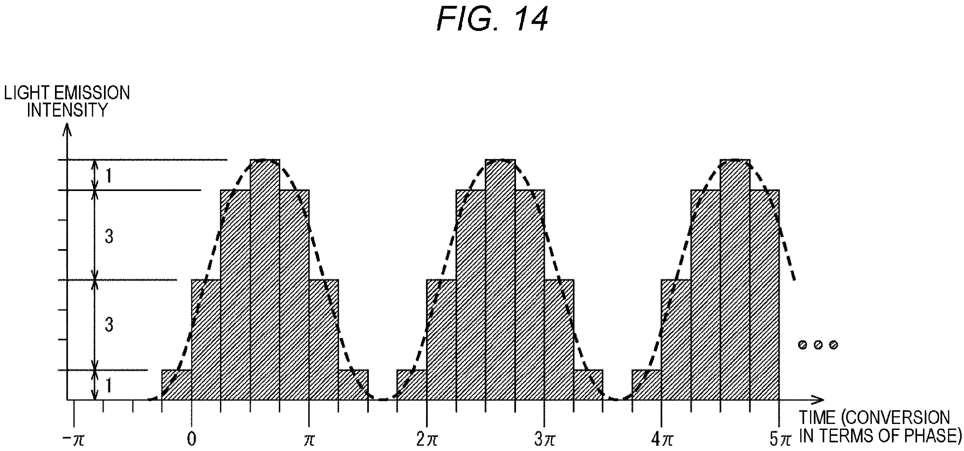

Fig. 14 illustrates a light emission intensity of the entire light emitting unit 21 at each timing in a conversion in terms of phase in a case where the twelve laser light sources 41A to 41L emit light as described with reference to Figs. 12 and 13.

When the light emission intensity in a case where the one laser light source 41 emits light is set to 1 and the number of the laser light sources 41 emitting light at each timing is summed up, the light emission intensity has symmetry in the time direction in the time width of one cycle around the peak value or the minimum value of the light emission intensity, and becomes the light emission intensity approximate to the sine wave indicated by the broken line, similarly to the case of the first configuration example illustrated in Fig. 7.

Thus, since the irradiation light emitted from the light emitting unit 21 can be a pseudo sine wave (pseudo sine wave), the cyclic error can be reduced, and the correction processing can be made unnecessary.

<6. Second embodiment of distance measurement module>

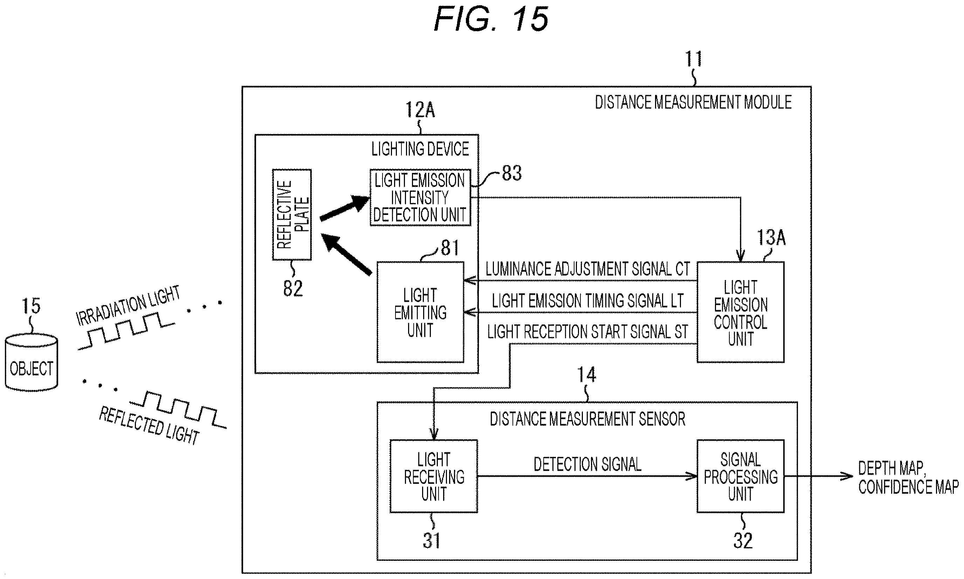

Fig. 15 is a block diagram illustrating a configuration example of a second embodiment of the distance measurement module to which the present technology is applied.

The distance measurement module 11 according to the second embodiment includes a lighting device 12A, a light emission control unit 13A, and the distance measurement sensor 14.

When the distance measurement module 11 in Fig. 15 is compared with the distance measurement module 11 in Fig. 1, the lighting device 12 in Fig. 1 is replaced with the lighting device 12A, the light emission control unit 13 in Fig. 1 is replaced with the light emission control unit 13A, and the others are similarly configured.

The lighting device 12A includes a light emitting unit 81, a reflective plate 82, and a light emission intensity detection unit 83.

The light emitting unit 81 is configured similarly to the light emitting unit 21 except that a luminance adjustment signal CT for controlling a drive current is further supplied from the light emission control unit 13A.

The light emitting unit 81 emits light while performing modulation at a timing depending on the light emission timing signal LT supplied from the light emission control unit 13, and emits irradiation light to the object 15. A light emission intensity when the light emitting unit 81 emits light is adjusted by the luminance adjustment signal CT supplied from the light emission control unit 13.

Note that, for example, similarly to the first configuration example illustrated in Fig. 5, the light emitting unit 81 is assumed to have a configuration in which the eight laser light sources 41 are arranged in a predetermined arrangement.

The reflective plate 82 reflects the light emitted from each laser light source 41 of the light emitting unit 81 and causes the light to be incident on the light emission intensity detection unit 83. Note that, the light emitted from each laser light source 41 of the light emitting unit 81 may be made incident on the light emission intensity detection unit 83 by using a light guide plate, a beam splitter, or the like instead of the reflective plate 82.

The light emission intensity detection unit 83 detects the light emission intensity (light emission luminance) of each laser light source 41 of the light emitting unit 81 reflected by the reflective plate 82 and incident thereon, and supplies a detection result to the light emission control unit 13A.

The light emission control unit 13A supplies the luminance adjustment signal CT to the light emitting unit 81 on the basis of the light emission intensity (light emission luminance) of each laser light source 41 of the light emitting unit 81 supplied from the light emission intensity detection unit 83. Similarly to the first embodiment, the light emission control unit 13A supplies the light emission timing signal LT to the light emitting unit 21 to control on/off of light emission, and supplies the light reception start signal ST to the distance measurement sensor 14 to control the light reception timing of the light receiving unit 31.

<7. Configuration example of light emitting unit>

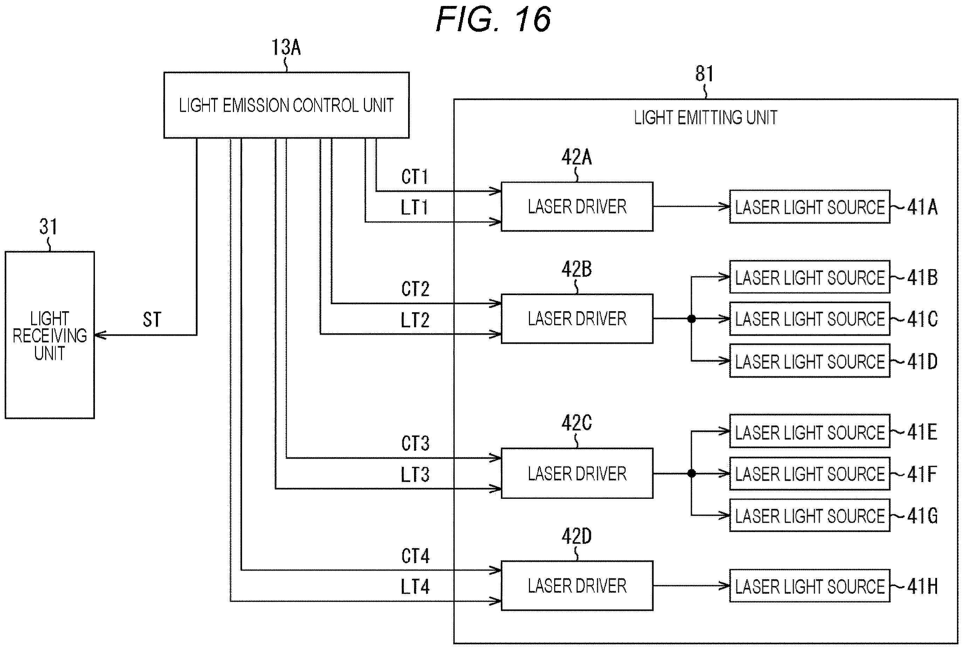

Fig. 16 is a block diagram illustrating details of the light emitting unit 81 and the light emission control unit 13A and the light receiving unit 31 according to the second embodiment.

The light emitting unit 81 is configured similarly to the light emitting unit 21 illustrated in Fig. 4 except that the luminance adjustment signal CT is newly supplied. The light emission control unit 13A supplies a luminance adjustment signal CT1 to the laser driver 42A, supplies a luminance adjustment signal CT2 to the laser driver 42B, supplies a luminance adjustment signal CT3 to the laser driver 42C, and supplies a luminance adjustment signal CT4 to the laser driver 42D.

Each laser driver 42 adjusts the light emission intensity of the laser light source 41 to be driven and controlled, on the basis of the supplied luminance adjustment signal CT.

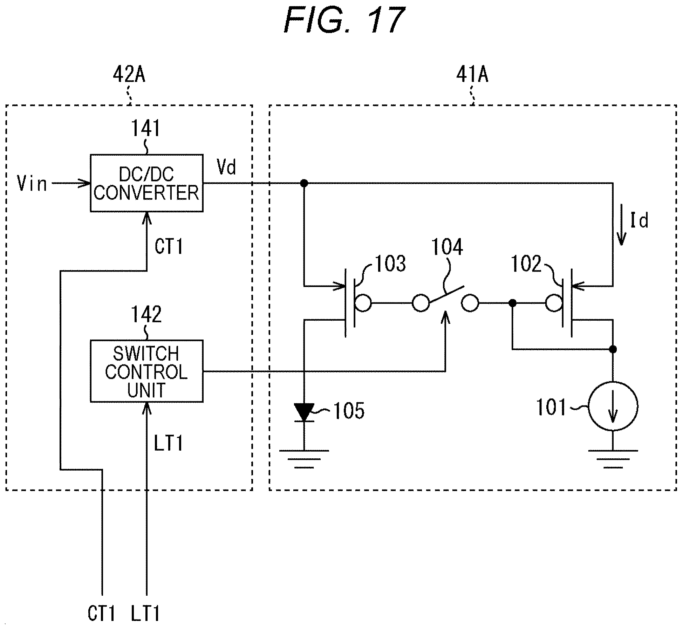

Fig. 17 illustrates a circuit configuration example of the laser driver 42A and the laser light source 41A driven and controlled by the laser driver 42A.

The laser driver 42A includes a DC/DC converter 141 and a switch control unit 142.

The laser light source 41A includes a constant current source 101, transistors 102 and 103, a switch 104, and a light emitting element 105. The light emitting element 105 is, for example, a VCSEL.

The transistors 102 and 103 include P-channel metal-oxide-semiconductor field-effect transistors (MOSFETs).

The source of the transistor 102 is connected to the output line of the DC/DC converter 141, the drain is connected to the ground (GND) via the constant current source 101, and the drain and the gate are connected to each other. Furthermore, the gate of the transistor 102 is connected to the gate of the transistor 103 via the switch 104.

The source of the transistor 103 is connected to the output line of the DC/DC converter 141, the drain is connected to the anode of the light emitting element 105, and the gate is connected to the gate and the drain of the transistor 102 via the switch 104.

The DC/DC converter 141 of the laser driver 42A converts a DC input voltage Vin into an output voltage Vd and supplies the output voltage Vd to the sources of the transistors 102 and 103. The DC/DC converter 141 adjusts the output voltage Vd on the basis of the supplied luminance adjustment signal CT1. Specifically, the DC/DC converter 141 increases the output voltage Vd in a case where a command to increase a current is supplied as the luminance adjustment signal CT1, and decreases the output voltage Vd in a case where a command to decrease the current is supplied.

The switch control unit 142 controls on/off of the switch 104 on the basis of the light emission timing signal LT1. Specifically, the switch control unit 142 turns on the switch 104 in a period in which the light emission timing signal LT1 at High is supplied, and turns off the switch 104 in a period in which the light emission timing signal LT1 at Low is supplied.

In a case where the switch 104 is controlled to be turned on, the constant current source 101 and the transistors 102 and 103 constitute a current mirror circuit, and a current Id identical to the current Id flowing through the transistor 102 flows through the transistor 103 and is further supplied to the light emitting element 105 as the drive current Id, so that the light emitting element 105 emits light.

In a case where the switch 104 is controlled to be turned off, the drive current Id does not flow through the light emitting element 105, so that the light emitting element 105 does not emit light.

The DC/DC converter 141 can control the drive current Id to be supplied to the light emitting element 105 by adjusting the output voltage Vd on the basis of the luminance adjustment signal CT1.

Although not illustrated, circuit configurations of the laser driver 42D and the laser light source 41H driven and controlled by the laser driver 42D are configured similarly to those of the laser driver 42A and the laser light source 41A in Fig. 17.

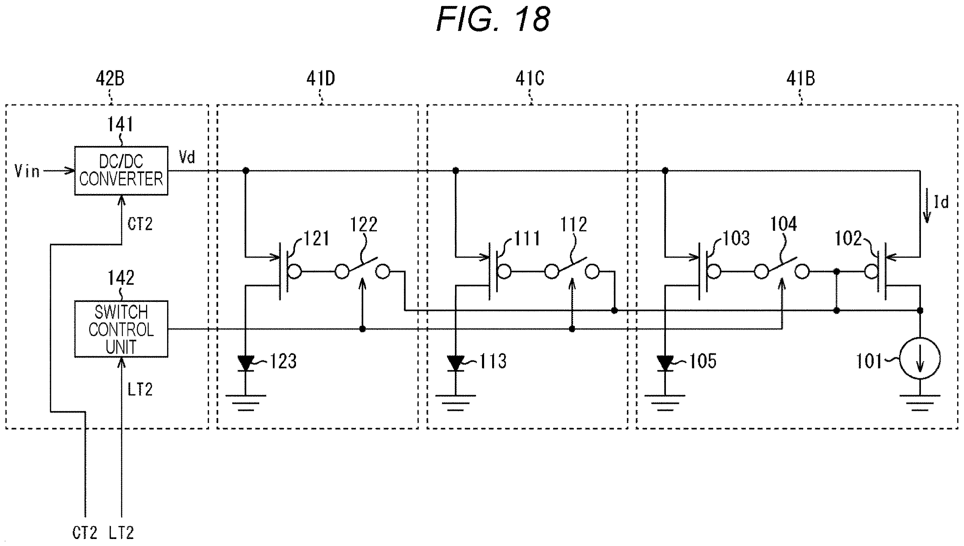

Fig. 18 illustrates a circuit configuration example of the laser driver 42B and the three laser light sources 41B to 41D driven and controlled by the laser driver 42B.

The laser driver 42B includes a DC/DC converter 141 and a switch control unit 142.

The laser light source 41B includes a constant current source 101, transistors 102 and 103, a switch 104, and a light emitting element 105. Since a configuration of the laser light source 41B is similar to that of the laser light source 41A in Fig. 17, the description thereof will be omitted.

The laser light source 41C includes a transistor 111, a switch 112, and a light emitting element 113. The source of the transistor 111 is connected to the output line of the DC/DC converter 141, the drain is connected to the anode of the light emitting element 113, and the gate is connected to the gate and the drain of the transistor 102 via the switch 112.

The laser light source 41D includes a transistor 121, a switch 122, and a light emitting element 123. The source of the transistor 121 is connected to the output line of the DC/DC converter 141, the drain is connected to the anode of the light emitting element 123, and the gate is connected to the gate and the drain of the transistor 102 via the switch 122.

The switches 104, 112, and 122 are turned on and off by the control of the switch control unit 142.

In a case where the switches 104, 112, and 122 are controlled to be turned on, the constant current source 101, the transistors 102, 103, 111, and 121 constitute a current mirror circuit, and a current Id identical to the current Id flowing through the transistor 102 flows through the transistors 103, 111, and 121 and is also supplied to the light emitting elements 105, 113, and 123 as the drive current Id, so that the light emitting elements 105, 113, and 123 emit light.

The DC/DC converter 141 can control the drive current Id supplied to the light emitting elements 105, 113, and 123 by adjusting an output voltage Vd on the basis of the luminance adjustment signal CT2.

Although not illustrated, circuit configurations of the laser driver 42C and the three laser light sources 41E to 41G driven and controlled by the laser driver 42C are configured similarly to those of the laser driver 42B and the laser light sources 41B to 41D of Fig. 18.

<8. Light emission intensity adjustment processing>

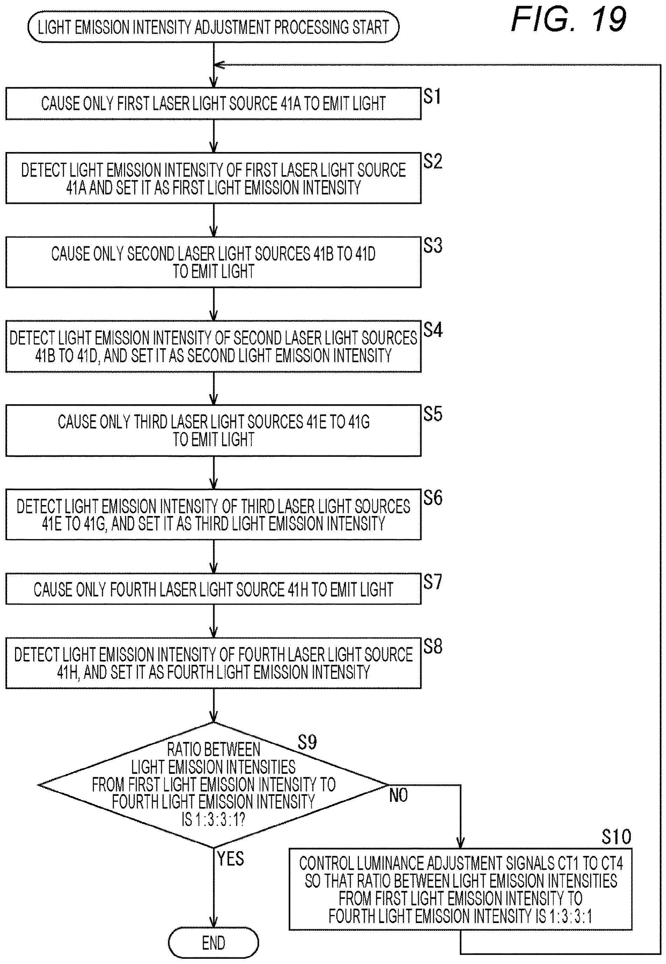

Next, light emission intensity adjustment processing by the distance measurement module 11 according to the second embodiment will be described with reference to a flowchart of Fig. 19. This processing is started, for example, when an instruction to start measurement is supplied to the distance measurement module 11.

First, in step S1, the light emission control unit 13A causes only the laser light source 41A (hereinafter, also referred to as the first laser light source 41A) to emit light among the eight laser light sources 41A to 41H.

More specifically, the light emission control unit 13A supplies the light emission timing signal LT1 that becomes High in a predetermined cycle and period to the laser driver 42A, and supplies the light emission timing signals LT2 to LT4 that are always Low to the laser drivers 42B to 42D. As a result, only the first laser light source 41A driven and controlled by the laser driver 42A emits light at a predetermined light emission timing.

In step S2, the light emission intensity detection unit 83 detects a light emission intensity of the first laser light source 41A reflected by the reflective plate 82 and incident, and supplies a detection result to the light emission control unit 13A. Here, the detected emission intensity is referred to as a first light emission intensity.

In step S3, the light emission control unit 13A causes only the laser light sources 41B to 41D (hereinafter, also referred to as second laser light sources 41B to 41D) to emit light among the eight laser light sources 41A to 41H.

More specifically, the light emission control unit 13A supplies the light emission timing signal LT2 that becomes High in a predetermined cycle and period to the laser driver 42B, and supplies the light emission timing signals LT1, LT3, and LT4 that are always Low to the laser drivers 42A, 42C, and 42D. As a result, only the second laser light sources 41B to 41D driven and controlled by the laser driver 42B emit light at a predetermined light emission timing.

In step S4, the light emission intensity detection unit 83 detects a light emission intensity of the second laser light sources 41B to 41D reflected by the reflective plate 82 and incident, and supplies a detection result to the light emission control unit 13A. Here, the detected emission intensity is referred to as a second light emission intensity.

In step S5, the light emission control unit 13A causes only the laser light sources 41E to 41G (hereinafter, also referred to as third laser light sources 41E to 41G) to emit light among the eight laser light sources 41A to 41H.

More specifically, the light emission control unit 13A supplies the light emission timing signal LT3 that becomes High in a predetermined cycle and period to the laser driver 42C, and supplies the light emission timing signals LT1, LT2, and LT4 that are always Low to the laser drivers 42A, 42B, and 42D. As a result, only the third laser light sources 41E to 41G driven and controlled by the laser driver 42C emit light at a predetermined light emission timing.

In step S6, the light emission intensity detection unit 83 detects a light emission intensity of the third laser light sources 41E to 41G reflected by the reflective plate 82 and incident, and supplies a detection result to the light emission control unit 13A. Here, the detected emission intensity is referred to as a third light emission intensity.

In step S7, the light emission control unit 13A causes only the laser light source 41H (hereinafter, also referred to as a fourth laser light source 41H) to emit light among the eight laser light sources 41A to 41H.

More specifically, the light emission control unit 13A supplies the light emission timing signal LT4 that becomes High in a predetermined cycle and period to the laser driver 42D, and supplies the light emission timing signals LT1 to LT3 that are always Low to the laser drivers 42A to 42C. As a result, only the fourth laser light source 41H driven and controlled by the laser driver 42D emits light at a predetermined light emission timing.

In step S8, the light emission intensity detection unit 83 detects a light emission intensity of the fourth laser light source 41H reflected by the reflective plate 82 and incident, and supplies a detection result to the light emission control unit 13A. Here, the detected emission intensity is referred to as a fourth light emission intensity.

In steps S1 to S8 described above, the cycles and periods are the same of light emission ON (High) of the light emission timing signal LT in a case where a predetermined laser light source 41 is caused to emit light. That is, light emission conditions are the same when the laser light sources 41 emit light. Furthermore, the luminance adjustment signals CT1 to CT4 at the first time are initial values (default values) determined in advance.

In step S9, the light emission control unit 13A determines whether a ratio between light emission intensities from the first light emission intensity to the fourth light emission intensity obtained in the above-described processing is 1 : 3 : 3 : 1, that is, whether the first light emission intensity : the second light emission intensity : the third light emission intensity : the fourth light emission intensity = 1 : 3 : 3 : 1. In a case where the ratio between the light emission intensities from the first light emission intensity to the fourth light emission intensity is 1 : 3 : 3 : 1 within a predetermined error range determined in advance, the light emission control unit 13A determines that the ratio between the light emission intensities from the first light emission intensity to the fourth light emission intensity is 1 : 3 : 3 : 1.

In a case where it is determined in step S9 that the ratio between the light emission intensities from the first light emission intensity to the fourth light emission intensity is not 1 : 3 : 3 : 1, the processing proceeds to step S10, and the light emission control unit 13A controls the luminance adjustment signals CT1 to CT4 so that the ratio between the light emission intensities from the first light emission intensity to the fourth light emission intensity is 1 : 3 : 3 : 1.

After step S10, the processing returns to step S1, and the processing of steps S1 to S9 described above is executed. That is, after the luminance adjustment signals CT1 to CT4 are changed and the drive current Id is adjusted, it is determined again whether the ratio between the light emission intensities from the first light emission intensity to the fourth light emission intensity is 1 : 3 : 3 : 1.

On the other hand, in a case where it is determined in step S9 that the ratio between the light emission intensities from the first light emission intensity to the fourth light emission intensity is 1 : 3 : 3 : 1, the light emission intensity adjustment processing ends.

After the light emission intensity adjustment processing, the eight laser light sources 41A to 41H emit light by the light emission control described with reference to Fig. 6, and the light receiving unit 31 receives the reflected light reflected by the object 15 as an object to be measured. Then, the signal processing unit 32 outputs a depth map representing distance information to the object 15 and a confidence map as measurement results on the basis of a light reception result of the light receiving unit 31.

As described above, with the distance measurement module 11 according to the second embodiment, a function is provided of monitoring the light emission intensity when each laser light source 41 of the light emitting unit 81 emits light, and control can be performed so that the ratio between the light emission intensities of the laser light sources 41 is a predetermined ratio, so that the irradiation light emitted by the light emitting unit 21 can more precisely be made into a pseudo sine wave (pseudo sine wave).

Note that, in the second embodiment described above, as an example, a case has been described where the light emitting unit 81 is the first configuration example illustrated in Fig. 5; however, a monitoring function can be similarly added also in a case where the light emitting unit 81 has a configuration of the modification of the first configuration example illustrated in Fig. 8. Furthermore, also in a case where the light emitting unit 81 has a configuration of the second configuration example illustrated in Fig. 9, a monitoring function can be similarly added.

<9. Chip configuration example of distance measurement module>

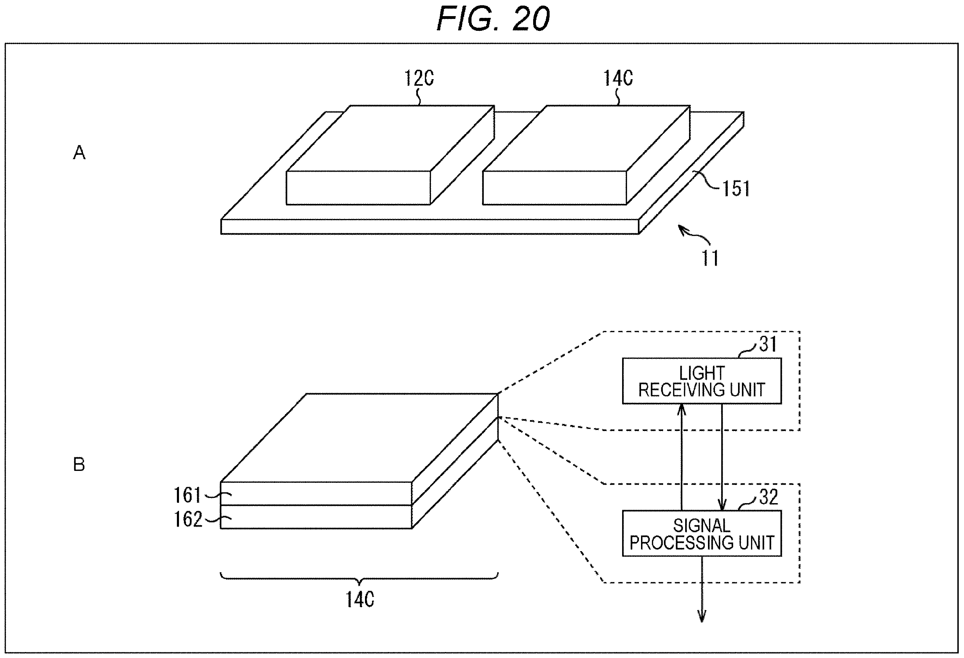

Fig. 20 is a perspective view illustrating a chip configuration example of the distance measurement module 11.

For example, as illustrated in A of Fig. 20, the distance measurement module 11 can include a first chip 12C as the lighting device 12 or 12A and a second chip 14C as the distance measurement sensor 14 that are formed on a relay substrate (interposer substrate) 151. The light emission control unit 13 is included in either the first chip 12C or the second chip 14C.

As illustrated in B of Fig. 20, the second chip 14C as the distance measurement sensor 14 can include one chip in which a first die (substrate) 161 and a second die (substrate) 162 are stacked.

The first die 161 includes (a circuit as) the light receiving unit 31 including the pixel array, an AD conversion unit that performs AD conversion of a detection signal, and the like, and the second die 162 includes a logic circuit including the signal processing unit 32.

Note that, the lighting device 12 or 12A and the distance measurement sensor 14 may be separated independently without being integrated using the relay substrate 151 as illustrated in Fig. 20. Furthermore, the distance measurement sensor 14 may include three layers in which another logic die is stacked in addition to the first die 161 and the second die 162. Alternatively, four or more layers of dies (substrates) may be stacked.

<10. Configuration example of electronic device>

The above-described distance measurement module 11 can be mounted on, for example, an electronic device such as a smartphone, a tablet terminal, a mobile phone, a personal computer, a game machine, a television receiver, a wearable terminal, a digital still camera, or a digital video camera.

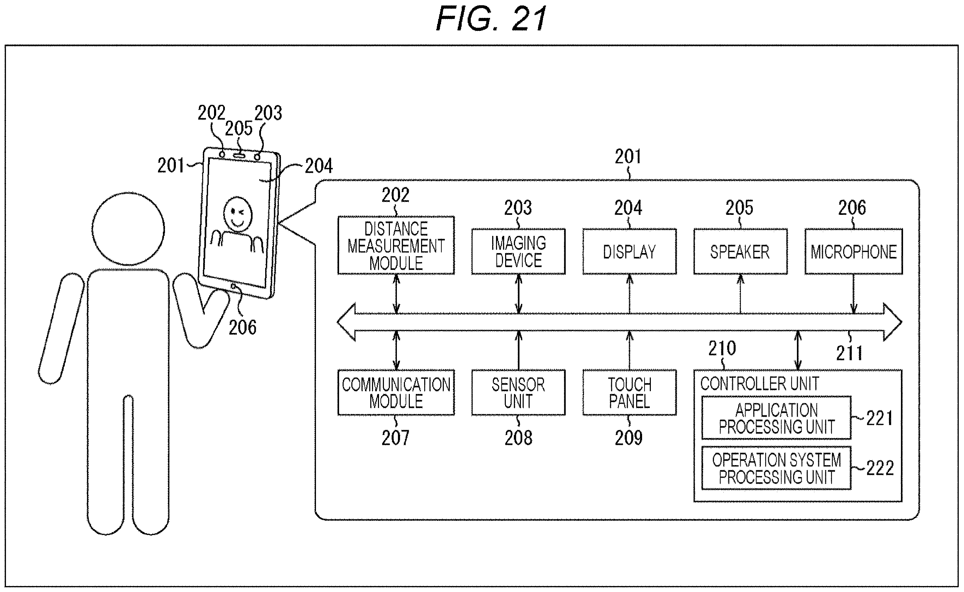

Fig. 21 is a block diagram illustrating a configuration example of a smartphone as an electronic device on which the distance measurement module is mounted.

As illustrated in Fig. 21, a smartphone 201 includes a distance measurement module 202, an imaging device 203, a display 204, a speaker 205, a microphone 206, a communication module 207, a sensor unit 208, a touch panel 209, and a controller unit 210 that are connected to each other via a bus 211. Furthermore, the controller unit 210 has functions as an application processing unit 221 and an operation system processing unit 222 by executing a program by a CPU.

The distance measurement module 11 of Fig. 1 is applied to the distance measurement module 202. For example, the distance measurement module 202 is arranged in the front surface of the smartphone 201 and performs distance measurement for a user of the smartphone 201, thereby being able to output depth values of the surface shapes of the user's face, hand, finger, and the like as distance measurement results.

The imaging device 203 is arranged in the front surface of the smartphone 201 and performs imaging of the user of the smartphone 201 as a subject, thereby acquiring an image of the user. Note that, although not illustrated, the imaging device 203 may be arranged on the back surface of the smartphone 201.

The display 204 displays an operation screen for performing processing by the application processing unit 221 and the operation system processing unit 222, an image captured by the imaging device 203, and the like. The speaker 205 and the microphone 206 output the voice of the other party and collect the voice of the user when a call is made with the smartphone 201, for example.

The communication module 207 performs communication via a communication network. The sensor unit 208 senses speed, acceleration, proximity, and the like, and the touch panel 209 acquires a user's touch operation on the operation screen displayed on the display 204.

The application processing unit 221 performs processing for providing various services by the smartphone 201. For example, the application processing unit 221 can perform processing of creating a face by computer graphics that virtually reproduces the user's facial expression on the basis of the depth supplied from the distance measurement module 202, and displaying the face on the display 204. Furthermore, the application processing unit 221 can perform processing of creating, for example, three-dimensional shape data of any three-dimensional object on the basis of the depth supplied from the distance measurement module 202.

The operation system processing unit 222 performs processing for implementing basic functions and operations of the smartphone 201. For example, the operation system processing unit 222 can perform processing of authenticating the user's face and unlocking the smartphone 201 on the basis of the depth value supplied from the distance measurement module 202. Furthermore, the operation system processing unit 222 can perform, for example, processing of recognizing the user's gesture on the basis of the depth value supplied from the distance measurement module 202, and performs processing of inputting various operations corresponding to the gesture.

In the smartphone 201 configured as described above, for example, the depth map can be generated with high accuracy and high speed by applying the above-described distance measurement module 11. As a result, the smartphone 201 can more accurately detect distance measurement information.

<11. Application example to mobile body>

The technology according to the present disclosure (the present technology) can be applied to various products. The technology according to the present disclosure may be implemented as a device mounted on any type of mobile body, for example, a car, an electric car, a hybrid electric car, a motorcycle, a bicycle, a personal mobility, an airplane, a drone, a ship, a robot, or the like.

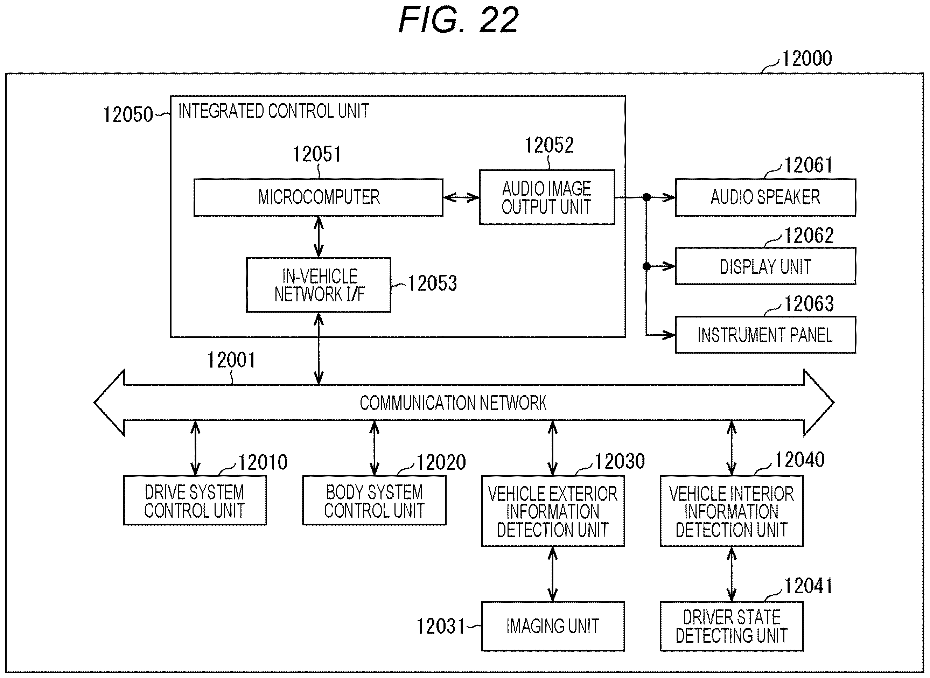

Fig. 22 is a block diagram illustrating a schematic configuration example of a vehicle control system that is an example of a mobile body control system to which the technology according to the present disclosure can be applied.

The vehicle control system 12000 includes a plurality of electronic control units connected to each other via a communication network 12001. In the example illustrated in Fig. 22, the vehicle control system 12000 includes a drive system control unit 12010, a body system control unit 12020, a vehicle exterior information detection unit 12030, a vehicle interior information detection unit 12040, and an integrated control unit 12050. Furthermore, as functional configurations of the integrated control unit 12050, a microcomputer 12051, an audio image output unit 12052, and an in-vehicle network interface (I/F) 12053 are illustrated.

The drive system control unit 12010 controls operation of devices related to a drive system of a vehicle in accordance with various programs. For example, the drive system control unit 12010 functions as a control device of a driving force generating device for generating driving force of the vehicle, such as an internal combustion engine or a driving motor, a driving force transmitting mechanism for transmitting driving force to wheels, a steering mechanism for adjusting a steering angle of the vehicle, a braking device for generating braking force of the vehicle, and the like.

The body system control unit 12020 controls operation of various devices equipped on the vehicle body in accordance with various programs. For example, the body system control unit 12020 functions as a control device of a keyless entry system, a smart key system, a power window device, or various lamps such as a head lamp, a back lamp, a brake lamp, a turn signal lamp, and a fog lamp. In this case, to the body system control unit 12020, a radio wave transmitted from a portable device that substitutes for a key, or signals of various switches can be input. The body system control unit 12020 accepts input of these radio waves or signals and controls a door lock device, power window device, lamp, and the like of the vehicle.

The vehicle exterior information detection unit 12030 detects information on the outside of the vehicle on which the vehicle control system 12000 is mounted. For example, an imaging unit 12031 is connected to the vehicle exterior information detection unit 12030. The vehicle exterior information detection unit 12030 causes the imaging unit 12031 to capture an image outside the vehicle and receives the image captured. The vehicle exterior information detection unit 12030 may perform object detection processing or distance detection processing on a person, a car, an obstacle, a sign, a character on a road surface, or the like, on the basis of the received image.

The imaging unit 12031 is an optical sensor that receives light and outputs an electric signal corresponding to an amount of received light. The imaging unit 12031 can output the electric signal as an image, or as distance measurement information. Furthermore, the light received by the imaging unit 12031 may be visible light, or invisible light such as infrared rays.

The vehicle interior information detection unit 12040 detects information on the inside of the vehicle. The vehicle interior information detection unit 12040 is connected to, for example, a driver state detecting unit 12041 that detects a state of a driver. The driver state detecting unit 12041 includes, for example, a camera that captures an image of the driver, and the vehicle interior information detection unit 12040 may calculate a degree of fatigue or a degree of concentration of the driver, or determine whether or not the driver is dozing, on the basis of the detection information input from the driver state detecting unit 12041.

The microcomputer 12051 can calculate a control target value of the driving force generating device, the steering mechanism, or the braking device on the basis of the information on the inside and outside of the vehicle acquired by the vehicle exterior information detection unit 12030 or the vehicle interior information detection unit 12040, and output a control command to the drive system control unit 12010. For example, the microcomputer 12051 can perform cooperative control aiming for implementing functions of advanced driver assistance system (ADAS) including collision avoidance or shock mitigation of the vehicle, follow-up traveling based on an inter-vehicle distance, vehicle speed maintaining traveling, vehicle collision warning, vehicle lane departure warning, or the like.

Furthermore, the microcomputer 12051 can perform cooperative control aiming for automatic driving that autonomously travels without depending on operation of the driver, or the like, by controlling the driving force generating device, the steering mechanism, the braking device, or the like on the basis of information on the periphery of the vehicle acquired by the vehicle exterior information detection unit 12030 or the vehicle interior information detection unit 12040.

Furthermore, the microcomputer 12051 can output a control command to the body system control unit 12020 on the basis of information on the outside of the vehicle acquired by the vehicle exterior information detection unit 12030. For example, the microcomputer 12051 can perform cooperative control aiming for preventing dazzling such as switching from the high beam to the low beam, by controlling the head lamp depending on a position of a preceding vehicle or an oncoming vehicle detected by the vehicle exterior information detection unit 12030.

The audio image output unit 12052 transmits at least one of audio or image output signal to an output device capable of visually or aurally notifying an occupant in the vehicle or the outside of the vehicle of information. In the example of Fig. 22, as the output device, an audio speaker 12061, a display unit 12062, and an instrument panel 12063 are illustrated. The display unit 12062 may include, for example, at least one of an on-board display or a head-up display.

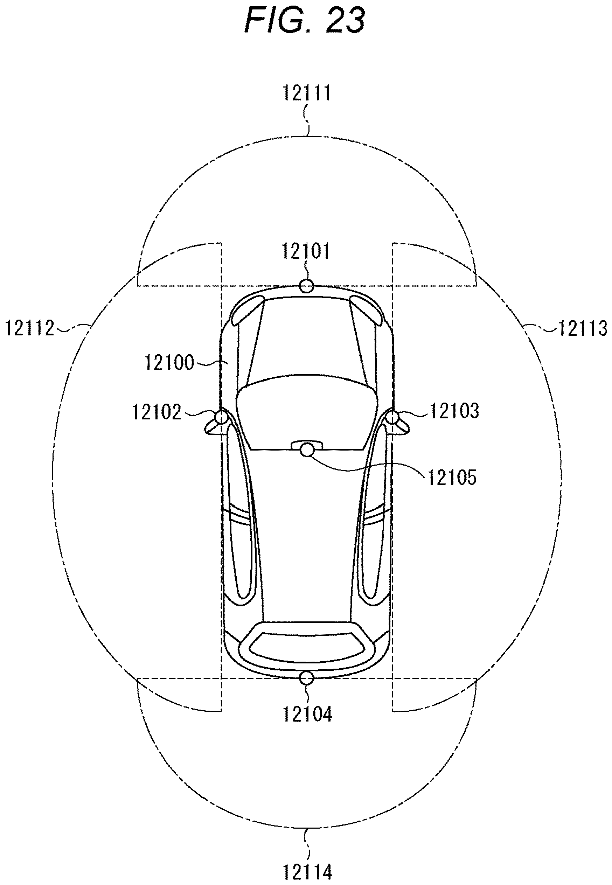

Fig. 23 is a diagram illustrating an example of installation positions of the imaging unit 12031.

In Fig. 23, a vehicle 12100 includes imaging units 12101, 12102, 12103, 12104, and 12105 as the imaging unit 12031.

The imaging units 12101, 12102, 12103, 12104, and 12105 are provided, for example, at a position of the front nose, the side mirror, the rear bumper, the back door, the upper part of the windshield in the vehicle interior, or the like, of a vehicle 12100. The imaging unit 12101 provided at the front nose and the imaging unit 12105 provided at the upper part of the windshield in the vehicle interior mainly acquire images ahead of the vehicle 12100. The imaging units 12102 and 12103 provided at the side mirrors mainly acquire images on the sides of the vehicle 12100. The imaging unit 12104 provided at the rear bumper or the back door mainly acquires an image behind the vehicle 12100. The front images acquired by the imaging units 12101 and 12105 are mainly used for detection of a preceding vehicle, a pedestrian, an obstacle, a traffic signal, a traffic sign, a lane, or the like.

Note that, Fig. 23 illustrates an example of imaging ranges of the imaging units 12101 to 12104. An imaging range 12111 indicates an imaging range of the imaging unit 12101 provided at the front nose, imaging ranges 12112 and 12113 respectively indicate imaging ranges of the imaging units 12102 and 12103 provided at the side mirrors, an imaging range 12114 indicates an imaging range of the imaging unit 12104 provided at the rear bumper or the back door. For example, image data captured by the imaging units 12101 to 12104 are superimposed on each other, whereby an overhead image is obtained of the vehicle 12100 viewed from above.

At least one of the imaging units 12101 to 12104 may have a function of acquiring distance information. For example, at least one of the imaging units 12101 to 12104 may be a stereo camera including a plurality of imaging elements, or may be an imaging element including pixels for phase difference detection.

For example, on the basis of the distance information obtained from the imaging units 12101 to 12104, the microcomputer 12051 obtains a distance to each three-dimensional object within the imaging ranges 12111 to 12114, and a temporal change of the distance (relative speed to the vehicle 12100), thereby being able to extract, as a preceding vehicle, a three-dimensional object that is in particular a closest three-dimensional object on a traveling path of the vehicle 12100 and traveling at a predetermined speed (for example, greater than or equal to 0 km/h) in substantially the same direction as that of the vehicle 12100. Moreover, the microcomputer 12051 can set an inter-vehicle distance to be ensured in advance in front of the preceding vehicle, and can perform automatic brake control (including follow-up stop control), automatic acceleration control (including follow-up start control), and the like. As described above, it is possible to perform cooperative control aiming for automatic driving that autonomously travels without depending on operation of the driver, or the like.

For example, on the basis of the distance information obtained from the imaging units 12101 to 12104, the microcomputer 12051 can extract three-dimensional object data regarding the three-dimensional object by classifying the objects into a two-wheeled vehicle, a regular vehicle, a large vehicle, a pedestrian, and other three-dimensional objects such as a utility pole, and use the data for automatic avoidance of obstacles. For example, the microcomputer 12051 identifies obstacles in the periphery of the vehicle 12100 into an obstacle visually recognizable to the driver of the vehicle 12100 and an obstacle difficult to visually recognize. Then, the microcomputer 12051 determines a collision risk indicating a risk of collision with each obstacle, and when the collision risk is greater than or equal to a set value and there is a possibility of collision, the microcomputer 12051 outputs an alarm to the driver via the audio speaker 12061 and the display unit 12062, or performs forced deceleration or avoidance steering via the drive system control unit 12010, thereby being able to perform driving assistance for collision avoidance.

At least one of the imaging units 12101 to 12104 may be an infrared camera that detects infrared rays. For example, the microcomputer 12051 can recognize a pedestrian by determining whether or not a pedestrian exists in the captured images of the imaging units 12101 to 12104. Such pedestrian recognition is performed by, for example, a procedure of extracting feature points in the captured images of the imaging units 12101 to 12104 as infrared cameras, and a procedure of performing pattern matching processing on a series of feature points indicating a contour of an object to determine whether or not the object is a pedestrian. When the microcomputer 12051 determines that a pedestrian exists in the captured images of the imaging units 12101 to 12104 and recognizes the pedestrian, the audio image output unit 12052 controls the display unit 12062 so that a rectangular contour line for emphasis is superimposed and displayed on the recognized pedestrian. Furthermore, the audio image output unit 12052 may control the display unit 12062 so that an icon or the like indicating the pedestrian is displayed at a desired position.

In the above, an example has been described of the vehicle control system to which the technology according to the present disclosure can be applied. The technology according to the present disclosure can be applied to the vehicle exterior information detection unit 12030 and the vehicle interior information detection unit 12040 among the configurations described above. Specifically, by using distance measurement by the distance measurement module 11 as the vehicle exterior information detection unit 12030 and the vehicle interior information detection unit 12040, it is possible to perform processing of recognizing a gesture of the driver, execute various (for example, an audio system, a navigation system, and an air conditioning system) operations in accordance with the gesture, and more accurately detect the state of the driver. Furthermore, unevenness of the road surface can be recognized by using the distance measurement by the distance measurement module 11 and reflected in control of suspension.

Note that, the present technology can be applied to a method for performing amplitude modulation of light projected onto an object, which is referred to as a continuous-wave method among indirect ToF methods. Furthermore, as a structure of a photodiode of the light receiving unit 31, the present technology can be applied to a distance measurement sensor having a structure in which charges are distributed to two charge accumulation units, such as a distance measurement sensor having a current assisted photonic demodulator (CAPD) structure or a gate-type distance measurement sensor that alternately applies pulses of the charges of the photodiode to two gates.

The embodiment of the present technology is not limited to the embodiments described above, and various modifications are possible without departing from the gist of the present technology.

As long as inconsistency does not occur, each of a plurality of the present technologies described in this specification can be implemented alone independently. Of course, it is also possible to implement by combining any of the plurality of present technologies. For example, a part or all of the present technology described in any of the embodiments can be implemented in combination with a part or all of the present technology described in other embodiments. Furthermore, a part or all of any of the present technologies described above can be implemented in combination with another technology not described above.

Furthermore, for example, the configuration described as one device (or processing unit) may be divided and configured as a plurality of devices (or processing units). Conversely, configurations described as a plurality of devices (or processing units) in the above may be collectively configured as one device (or processing unit). Furthermore, configurations other than those described above may be added to the configuration of each device (or each processing unit), of course. Moreover, as long as the configuration and operation of the system as a whole are substantially the same, a part of the configuration of a certain device (or processing unit) may be included in the configuration of another device (or another processing unit).

Moreover, in the present specification, a system means a set of a plurality of constituents (device, module (component), and the like), and it does not matter whether or not all of the constituents are in the same cabinet. Thus, a plurality of devices that is accommodated in a separate cabinet and connected to each other via a network and one device that accommodates a plurality of modules in one cabinet are both systems.

Note that, the effects described in the present specification are merely examples and are not limited, and may have effects other than those described in the present specification.

Note that, the present technology can have the following configurations.

(1) A lighting device including:

a plurality of light sources including a first light source and a second light source; and
a drive unit that drives the plurality of light sources, in which
the drive unit causes the first light source and the second light source to emit light at different timings and light emission periods to cause a light emission intensity by the plurality of light sources to have symmetry in a time direction in a time width of one cycle around a peak value or a minimum value.

(2) The lighting device according to (1), in which
the drive unit causes the first light source and the second light source to emit light at different timings and light emission periods to cause the light emission intensity by the plurality of light sources to be a pseudo sine wave.
(3) The lighting device according to (1) or (2), in which

the plurality of light sources includes the first light source and the second light source, and a third light source and a fourth light source, and
the drive unit causes the first light source to the fourth light source to emit light to cause a ratio between light emission intensities from the first light source to the fourth light source to be 1 : 3 : 3 : 1.

(4) The lighting device according to (3), in which
the light emission intensity of the second light source is three times the light emission intensity of the first light source.
(5) The lighting device according to (3), in which
the second light source includes three pieces of the first light sources.
(6) The lighting device according to (1) or (2), in which

the plurality of light sources includes the first light source and the second light source, and a third light source and a fourth light source,

the drive unit

drives the first light source on the basis of a first light emission timing signal,

drives the second light source on the basis of a second light emission timing signal,

drives the third light source on the basis of a signal obtained by delaying the first light emission timing signal by a predetermined time by a first delay circuit, and

drives the fourth light source on the basis of a signal obtained by delaying the second light emission timing signal by a predetermined time by a second delay circuit.

(7) The lighting device according to (6), in which
an amount of delay of the first delay circuit and an amount of delay of the second delay circuit are equal to each other.

(8) The lighting device according to any of (1) to (7), further including

a light emission intensity detection unit that detects light emission intensities of the plurality of light sources, in which

the light emission intensities of the plurality of light sources are adjusted depending on detection values of the light emission intensity detection unit.

(9) A method for controlling a lighting device including:

a plurality of light sources including a first light source and a second light source; and
a drive unit that drives the plurality of light sources, the method including

causing, by the drive unit, the first light source and the second light source to emit light at different timings and light emission periods to cause a light emission intensity by the plurality of light sources to have symmetry in a time direction in a time width of one cycle around a peak value or a minimum value.

(10) A distance measurement module including:

a lighting device; and
a distance measurement sensor,
in which
the lighting device includes:

a plurality of light sources including a first light source and a second light source; and
a drive unit that drives the plurality of light sources, in which
the drive unit causes the first light source and the second light source to emit light at different timings and light emission periods to cause a light emission intensity by the plurality of light sources to have symmetry in a time direction in a time width of one cycle around a peak value or a minimum value.

REFERENCE SIGNS LIST

| 11 | Distance measurement module |
| 12, 12A | Lighting device |
| 12C | First chip |
| 13, 13A | Light emission control unit |
| 14 | Distance measurement sensor |
| 14C | Second chip |
| 15 | Object |
| 21 | Light emitting unit |
| 31 | Light receiving unit |
| 32 | Signal processing unit |
| 41 (41A to 41L) | Laser light source |
| 42 (42A to 42H) | Laser driver |
| 43 (43X, 43Y) | Laser light source |
| 61 (61A to 61F) | Delay circuit |

| 81 | Light emitting unit |
| 82 | Reflective plate |
| 83 | Light emission intensity detection unit |
| 201 | Smartphone |
| 202 | Distance measurement module |

**Claims**

1. A lighting device comprising:

   a plurality of light sources including a first light source and a second light source; and
   a drive unit that drives the plurality of light sources,
   wherein
   the drive unit causes the first light source and the second light source to emit light at different timings and light emission periods to cause a light emission intensity by the plurality of light sources to have symmetry in a time direction in a time width of one cycle around a peak value or a minimum value.

2. The lighting device according to claim 1, wherein
   the drive unit causes the first light source and the second light source to emit light at different timings and light emission periods to cause the light emission intensity by the plurality of light sources to be a pseudo sine wave.

3. The lighting device according to claim 1, wherein

   the plurality of light sources includes the first light source and the second light source, and a third light source and a fourth light source, and
   the drive unit causes the first light source to the fourth light source to emit light to cause a ratio between light emission intensities from the first light source to the fourth light source to be 1 : 3 : 3 : 1.

4. The lighting device according to claim 3, wherein
   the light emission intensity of the second light source is three times the light emission intensity of the first light source.

5. The lighting device according to claim 3, wherein
   the second light source includes three pieces of the first light sources.

6. The lighting device according to claim 1, wherein

   the plurality of light sources includes the first light source and the second light source, and a third light source and a fourth light source,
   the drive unit
   drives the first light source on a basis of a first light emission timing signal,
   drives the second light source on a basis of a second light emission timing signal,
   drives the third light source on a basis of a signal obtained by delaying the first light emission timing signal by a predetermined time by a first delay circuit, and
   drives the fourth light source on a basis of a signal obtained by delaying the second light emission timing signal by a predetermined time by a second delay circuit.

7. The lighting device according to claim 6, wherein
   an amount of delay of the first delay circuit and an amount of delay of the second delay circuit are equal to each other.

8. The lighting device according to claim 1, further comprising

   a light emission intensity detection unit that detects light emission intensities of the plurality of light sources,
   wherein
   the light emission intensities of the plurality of light sources are adjusted depending on detection values of the light emission intensity detection unit.

9. A method for controlling a lighting device including:

a plurality of light sources including a first light source and a second light source; and
a drive unit that drives the plurality of light sources,
the method comprising
causing, by the drive unit, the first light source and the second light source to emit light at different timings and light emission periods to cause a light emission intensity by the plurality of light sources to have symmetry in a time direction in a time width of one cycle around a peak value or a minimum value.

10. A distance measurement module comprising:

a lighting device; and
a distance measurement sensor,
wherein
the lighting device includes:

a plurality of light sources including a first light source and a second light source; and
a drive unit that drives the plurality of light sources,
wherein
the drive unit causes the first light source and the second light source to emit light at different timings and light emission periods to cause a light emission intensity by the plurality of light sources to have symmetry in a time direction in a time width of one cycle around a peak value or a minimum value.

# FIG. 1

EP 4 040 186 A1

FIG. 2

PHASE 0   PHASE 90   PHASE 180   PHASE 270

TIME

LIGHT EMISSION PATTERN

$1/f$

TIME

LIGHT RECEPTION PATTERN

$\phi$

TIME

PHASE OF 0 DEGREES

$\Rightarrow Q_0$

PHASE OF 90 DEGREES

$\Rightarrow Q_{90}$

PHASE OF 180 DEGREES

$\Rightarrow Q_{180}$

PHASE OF 270 DEGREES

$\Rightarrow Q_{270}$

EP 4 040 186 A1

# FIG. 3

EP 4 040 186 A1

A

DISTANCE d

PHASE DIFFERENCE $\phi_{obs}$

B

DISTANCE d

PHASE DIFFERENCE $\phi_{linear}$

FIG. 4

# FIG. 5

FIG. 6

EP 4 040 186 A1

# FIG. 7

FIG. 8

# FIG. 9

EP 4 040 186 A1

## FIG. 10

EP 4 040 186 A1

# FIG. 11

A

start ── ST

$-\pi$  0  $\pi$  $2\pi$  $3\pi$  $4\pi$  $5\pi$  TIME (CONVERSION IN TERMS OF PHASE)

B

ON —  LT11
OFF —

$-\pi$  0  $\pi$  $2\pi$  $3\pi$  $4\pi$  $5\pi$  TIME (CONVERSION IN TERMS OF PHASE)

C

ON —  LT12
OFF —

$-\pi$  0  $\pi$  $2\pi$  $3\pi$  $4\pi$  $5\pi$  TIME (CONVERSION IN TERMS OF PHASE)

EP 4 040 186 A1

*FIG. 12*

## FIG. 13

A — LT12 — TIME (CONVERSION IN TERMS OF PHASE): $-\pi$, $0$, $\pi$, $2\pi$, $3\pi$, $4\pi$, $5\pi$; ON / OFF

B — LT12X — TIME (CONVERSION IN TERMS OF PHASE): $-\pi$, $0$, $\pi$, $2\pi$, $3\pi$, $4\pi$, $5\pi$; ON / OFF

C — LT12Y — TIME (CONVERSION IN TERMS OF PHASE): $-\pi$, $0$, $\pi$, $2\pi$, $3\pi$, $4\pi$, $5\pi$; ON / OFF

D — LT12Z — TIME (CONVERSION IN TERMS OF PHASE): $-\pi$, $0$, $\pi$, $2\pi$, $3\pi$, $4\pi$, $5\pi$; ON / OFF

FIG. 14

FIG. 15

FIG. 16

# FIG. 17

EP 4 040 186 A1

*FIG. 18*

EP 4 040 186 A1

*FIG. 19*

( LIGHT EMISSION INTENSITY ADJUSTMENT PROCESSING START )

CAUSE ONLY FIRST LASER LIGHT SOURCE 41A TO EMIT LIGHT — S1

DETECT LIGHT EMISSION INTENSITY OF FIRST LASER LIGHT SOURCE 41A AND SET IT AS FIRST LIGHT EMISSION INTENSITY — S2

CAUSE ONLY SECOND LASER LIGHT SOURCES 41B TO 41D TO EMIT LIGHT — S3

DETECT LIGHT EMISSION INTENSITY OF SECOND LASER LIGHT SOURCES 41B TO 41D, AND SET IT AS SECOND LIGHT EMISSION INTENSITY — S4

CAUSE ONLY THIRD LASER LIGHT SOURCES 41E TO 41G TO EMIT LIGHT — S5

DETECT LIGHT EMISSION INTENSITY OF THIRD LASER LIGHT SOURCES 41E TO 41G, AND SET IT AS THIRD LIGHT EMISSION INTENSITY — S6

CAUSE ONLY FOURTH LASER LIGHT SOURCE 41H TO EMIT LIGHT — S7

DETECT LIGHT EMISSION INTENSITY OF FOURTH LASER LIGHT SOURCE 41H, AND SET IT AS FOURTH LIGHT EMISSION INTENSITY — S8

RATIO BETWEEN LIGHT EMISSION INTENSITIES FROM FIRST LIGHT EMISSION INTENSITY TO FOURTH LIGHT EMISSION INTENSITY IS 1:3:3:1? — S9

NO → CONTROL LUMINANCE ADJUSTMENT SIGNALS CT1 TO CT4 SO THAT RATIO BETWEEN LIGHT EMISSION INTENSITIES FROM FIRST LIGHT EMISSION INTENSITY TO FOURTH LIGHT EMISSION INTENSITY IS 1:3:3:1 — S10

YES → ( END )

# FIG. 20

A

12C    14C

151

11

B

161
162

14C

LIGHT RECEIVING UNIT — 31

SIGNAL PROCESSING UNIT — 32

EP 4 040 186 A1

FIG. 21

EP 4 040 186 A1

*FIG. 22*

12000

12050 INTEGRATED CONTROL UNIT

12051 MICROCOMPUTER

12052 AUDIO IMAGE OUTPUT UNIT

12053 IN-VEHICLE NETWORK I/F

12001 COMMUNICATION NETWORK

12061 AUDIO SPEAKER

12062 DISPLAY UNIT

12063 INSTRUMENT PANEL

12010 DRIVE SYSTEM CONTROL UNIT

12020 BODY SYSTEM CONTROL UNIT

12030 VEHICLE EXTERIOR INFORMATION DETECTION UNIT

12031 IMAGING UNIT

12040 VEHICLE INTERIOR INFORMATION DETECTION UNIT

12041 DRIVER STATE DETECTING UNIT

## FIG. 23

## INTERNATIONAL SEARCH REPORT

International application No.

PCT/JP2020/035275

### A. CLASSIFICATION OF SUBJECT MATTER
G01S 7/484(2006.01)i; G01S 17/26(2020.01)i; H05B 47/155(2020.01)i
FI: G01S7/484; G01S17/26; H05B47/155

According to International Patent Classification (IPC) or to both national classification and IPC

### B. FIELDS SEARCHED

Minimum documentation searched (classification system followed by classification symbols)
G01S7/48-7/51, G01S17/00-17/95, G01C3/06, H05B47/155

Documentation searched other than minimum documentation to the extent that such documents are included in the fields searched

| | |
|---|---|
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2006-21720 A (NISAN MOTOR CO., LTD.) 26 January 2006 (2006-01-26) paragraphs [0011]-[0039], fig. 1-4 | 1-10 |
| A | JP 2010-190675 A (TOYOTA MOTOR CORP.) 02 September 2010 (2010-09-02) paragraphs [0020]-[0044], fig. 1-3 | 1-10 |
| A | US 2015/0304534 A1 (KADAMBI, Achuta) 22 October 2015 (2015-10-22) paragraphs [0045]-[0070], fig. 1-4 | 1-10 |
| A | JP 2013-76645 A (STANLEY ELECTRIC CO., LTD.) 25 April 2013 (2013-04-25) paragraphs [0014]-[0041], fig. 1-2 | 1-10 |
| A | JP 2018-124216 A (PULSTEC INDUSTRIAL CO., LTD.) 09 August 2018 (2018-08-09) paragraphs [0014]-[0025], fig. 1-2 | 1-10 |

☐ Further documents are listed in the continuation of Box C.  ☒ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 12 November 2020 (12.11.2020) | 01 December 2020 (01.12.2020) |

| Name and mailing address of the ISA/ | Authorized officer |
|---|---|
| Japan Patent Office 3-4-3, Kasumigaseki, Chiyoda-ku, Tokyo 100-8915, Japan | Telephone No. |

Form PCT/ISA/210 (second sheet) (January 2015)

<table>
<tr><td colspan="2" align="center">**INTERNATIONAL SEARCH REPORT**<br>Information on patent family members</td><td>International application No.<br><br>PCT/JP2020/035275</td></tr>
</table>

| Patent Documents referred in the Report | Publication Date | Patent Family | Publication Date |
|---|---|---|---|
| JP 2006-21720 A | 26 Jan. 2006 | (Family: none) | |
| JP 2010-190675 A | 12 Sep. 2010 | (Family: none) | |
| US 2015/0304534 A1 | 22 Oct. 2015 | (Family: none) | |
| JP 2013-76645 A | 25 Apr. 2013 | (Family: none) | |
| JP 2018-124216 A | 09 Aug. 2018 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016132235 A

- JP 2015018981 A